(19)

Europäisches Patentamt

European Patent Office

Office européen des brevets

(11) **EP 3 046 259 A1**

(12) **EUROPEAN PATENT APPLICATION**

(43) Date of publication:
**20.07.2016  Bulletin 2016/29**

(51) Int Cl.:
**H03M 13/11** *(2006.01)*          **H03M 13/25** *(2006.01)*
**H03M 13/00** *(2006.01)*

(21) Application number: **15151496.5**

(22) Date of filing: **16.01.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Alcatel Lucent
92100 Boulogne-Billancourt (FR)**

(72) Inventors:
• **Schmalen, Laurent
70435 Stuttgart (DE)**

• **Aref, Vahid
70499 Stuttgart (DE)**

(74) Representative: **2SPL Patentanwälte PartG mbB
Postfach 15 17 23
80050 München (DE)**

Remarks:
Amended claims in accordance with Rule 137(2) EPC.

(54) **Apparatuses and methods for ldpc convolutional encoding and decoding**

(57)     Embodiments relate to a concept for encoding/decoding a signal. The signal is encoded/decoded based on an LDPC convolutional encoding/decoding rule to obtain an encoded/decoded signal. The LDPC convolutional encoding/decoding rule is defined by a parity check matrix having $L^2$, $L \in \mathbb{N}$, component matrices, a row of the parity check matrix corresponding to $L$ component matrices and a column of the parity check matrix corresponding to $L$ component matrices. The $L^2$ component matrices comprise shortened component matrices and non-shortened component matrices, wherein a shortened component matrix represents a bipartite graph with fewer variable nodes than a non-shortened component matrix.

Fig. 7

**Description**

Embodiments of the present disclosure relate to communication systems and, more particularly, to communication systems employing Low-Density Parity-Check (LDPC) convolutional codes.

Background

A Low-Density Parity-Check (LDPC) code is a linear error correcting code for transmitting a message over a noisy transmission channel. It may be constructed using a sparse bipartite graph whose vertices can be divided into two disjoint independent sets $U$ and $V$ such that every edge connects a vertex in $U$ to one in $V$. Examples of bipartite graphs used for LPDC codes are the so-called Tanner graph or graph prototypes (protographs). In coding theory, bipartite graphs may be used to construct longer codes from smaller ones. Both LPDC encoders and LPDC decoders may employ these graphs extensively.

A possible application of LDPC codes is in optical or wireless communication systems. As the LDPC codes used in optical communications are mainly high-rate LDPC codes with rates often higher or equal than 0.8 (overhead smaller of equal than 25%), these LDPC codes are usually based on parity check matrices of size $M$ (rows) $\times$ $N$ (columns), with $M << N$.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the Maximum A-Posteriori (MAP) thresholds of the underlying ensemble in the limit of the block-length. Analogous to LDPC block codes, LDPC convolutional codes may be defined by sparse parity-check matrices, which allow them to be decoded using iterative message-passing algorithms. The merit in the design of spatially coupled LDPC codes is that their decoding is based on a local reduction in the remaining uncertainty of the values of information bits in a transmitted block. This reduction starts at the end of the chain due to the large number of low-degree check nodes at that position and then transfers to the neighboring positions through information propagation over the shared edges. The propagated information reduces the uncertainty in the values of the variable nodes in the neighboring position to enable a decoder to deduce their values based on the noisy information received from the channel along with the information propagated in the form of a decoding wave. The decoding wave must be triggered however: this trigger leads to an unavoidable rate loss, which means that the spectral efficiency of the overall system is decreased by a certain amount.

Hence, there is a desire to improve the spectral efficiency of systems employing spatially coupled LDPC codes.

Summary

Some simplifications may be made in the following summary, which is intended to highlight and introduce some aspects of the various exemplary embodiments, but such simplifications are not intended to limit the scope of the inventions. Detailed descriptions of a preferred exemplary embodiment adequate to allow those of ordinary skill in the art to make and use the inventive concepts will follow in later sections.

According to a first aspect of the present disclosure, embodiments provide a method for encoding a signal. The method includes encoding the signal based on an LDPC convolutional encoding rule to obtain an encoded signal. The LDPC convolutional encoding rule is defined by a parity check matrix having $L^2$, $L \in \mathbb{N}$, component matrices. A row of the parity check matrix corresponds to $L$ component matrices. Also, a column of the parity check matrix corresponds to $L$ component matrices. The $L^2$ component matrices of the parity check matrix comprise shortened component matrices and non-shortened component matrices. Thereby a shortened component matrix of said shortened component matrices represents a bipartite graph, e.g., a Tanner graph, with fewer variable nodes than a non-shortened component matrix of said non-shortened component matrices. Note that the term component matrix denotes a sub-matrix of smaller dimension than the whole parity check matrix.

The person skilled in the art of channel coding will appreciate that an LDPC (convolutional) code is commonly represented or defined by a corresponding parity check matrix. Thereby actual encoder or decoder implementations for the respective code may be derived from or adapted to the parity check matrix or the bipartite graph it represents. Physical encoder or decoder implementations for a certain parity check matrix may be numerous.

In some embodiments, a shortened component matrix of said shortened component matrices represents a respective bipartite graph, e.g., a Tanner graph, with the same number of check nodes as a non-shortened component matrix of said non-shortened component matrices.

In some embodiments, a non-shortened component matrix of said non-shortened component matrices has a dimension ($M \times N$) and a shortened component matrix of said shortened component matrices has a dimension ($M \times$

(**1** - $\alpha$)**N**), with $M, N \in \mathbb{N}$, $0 < \alpha < 1$, and $\alpha \in \mathbb{R}$.

In some embodiments, a row of L component matrices comprises T shortened component matrices and L-T non-shortened component matrices. In particular, each row of L component matrices may comprise T shortened component matrices and L-T non-shortened component matrices. The T shortened submatrices may be adjacent submatrices. All component matrices corresponding to a column of a shortened component matrix may be shortened component matrices, in some embodiments.

In some embodiments, a column of L component matrices of the parity check matrix has the same number of non-zero component matrices as a row of L component matrices of the parity check matrix. The number of non-zero component matrices may correspond to $\mu + 1$, wherein $\mu < L$ denotes the syndrome former memory of the LDPC convolutional encoding rule.

In some embodiments, the parity check matrix of the LDPC convolutional encoding rule corresponds to the tail-biting form

$$H = \begin{pmatrix} H_0(0) & & & & H_\mu(0) & \cdots & H_1(0) \\ H_1(1) & H_0(1) & & & & \ddots & \vdots \\ \vdots & H_1(2) & & & & & H_\mu(\mu-1) \\ H_\mu(\mu) & \vdots & \ddots & & & & \\ & H_\mu(\mu+1) & \ddots & & & & \\ & & & H_0(t) & & & \\ & & \ddots & H_1(t+1) & H_0(t+1) & & \\ & & & \vdots & \vdots & \ddots & \\ & & & H_\mu(t+\mu) & H_{\mu-1}(t+\mu) & \cdots & H_0(t+\mu) \end{pmatrix}.$$

Each column and/or row of component matrices may comprise or consist of L component matrices with $\mu+1$ non-zero component matrices, wherein $\mu$ denotes the syndrome former memory of the LDPC convolutional encoding rule. Thereby each row of component matrices may comprise $T \leq L$ shortened component matrices (zero or non-zero component matrices).

In some embodiments, a shortened component matrix represents a bipartite graph with (1-$\alpha$)N variable nodes, with $\alpha < 1$. A non-shortened component matrix represents a bipartite graph with N variable nodes, and the method further comprises, for each component matrix of the parity check matrix, receiving a signal block of k input bits. (1-$\alpha$)N code bits are provided based on the block of input bits and each of the shortened component matrices. N code bits are provided based on the block of input bits and each of the non-shortened component matrices.

In some embodiments, the method further comprises modulating an encoded signal block corresponding to one or more of the shortened component matrices with a different modulation format than an encoded signal block corresponding to one or more of the non-shortened component matrices. A modulation format associated with one or more of the shortened component matrices may be of lower order than a modulation format associated with one or more of the non-shortened component matrices.

According to a further aspect of the present disclosure, it is provided an apparatus for encoding a signal. The encoding apparatus comprises an LDPC convolutional encoder having an input for the signal and an output for an encoded signal. The LDPC convolutional encoder is configured to encode the signal based on an LDPC convolutional encoding rule to obtain the encoded signal. The LDPC convolutional encoding rule of the LDPC convolutional encoder is defined by a parity check matrix having $L^2$, $L \in \mathbb{N}$, component matrices. A row of the parity check matrix corresponds to L component matrices. A column of the parity check matrix corresponds to L component matrices. The $L^2$ component matrices comprise shortened component matrices and non-shortened component matrices, wherein a shortened component matrix represents a bipartite graph with fewer variable nodes than a non-shortened component matrix.

According to yet a further aspect of the present disclosure, it is also provided a method for decoding an encoded signal. The decoding method includes decoding the encoded signal based on an LDPC convolutional decoding rule to obtain a decoded signal. The LDPC convolutional decoding rule is defined by a parity check matrix having $L^2$, $L \in \mathbb{N}$, component matrices. A row of the parity check matrix corresponds to L component matrices. A column of the parity check matrix corresponds to L component matrices. The $L^2$ component matrices comprise shortened component matrices and non-shortened component matrices, wherein a shortened component matrix represents a bipartite graph with fewer variable nodes than a non-shortened component matrix.

Embodiments also provide an apparatus for decoding an encoded signal. The decoding apparatus comprises an LDPC convolutional decoder having an input for the encoded signal and an output for a decoded signal. The LDPC convolutional decoder is configured to decode the encoded signal based on an LDPC convolutional decoding rule to obtain the decoded signal. The LDPC convolutional decoding rule of the LDPC convolutional decoder is defined by a parity check matrix having $L^2$, $L \in \mathbb{N}$, component matrices. A row of the parity check matrix corresponds to $L$ component matrices. A column of the parity check matrix also corresponds to $L$ component matrices. The $L^2$ component matrices comprise shortened component matrices and non-shortened component matrices, wherein a shortened component matrix represents a bipartite graph with fewer variable nodes than a non-shortened component matrix.

Some embodiments may comprise analog and/or digital circuitry installed within the encoding and/or decoding apparatuses for performing the respective methods. Digital control circuitry, e.g., a DSP, an FPGA, an ASIC, or a general purpose processor, needs to be programmed accordingly. Hence, yet further embodiments also provide a computer program having a program code for performing embodiments of the encoding/decoding methods, when the computer program is executed on a computer or a programmable hardware device.

The person skilled in the art of channel coding will appreciate that the different aforementioned aspects of the persent disclosure may be combined in various ways to obtain various benefits. Embodiments may improve the Signal-to-Noise Ratio (SNR) and/or spectral efficiency performance of optical transport systems while keeping Very-Large-Scale Integration (VLSI) complexity low. An advantage of the new solution may be that the spectral efficiency of the system can be improved as the effective coding overhead may be reduced while keeping the correction abilities constant.

Brief description of the Figures

Some embodiments of apparatuses and/or methods will be described in the following by way of example only, and with reference to the accompanying figures, in which

Fig. 1     illustrates block diagram of a conventional row-layered LDPC decoding algorithm;

Fig. 2     illustrates a system model with a spatially coupled encoder and a windowed decoder;

Fig. 3     shows four phases of windowed decoding of spatially coupled LDPC convolutional codes;

Fig. 4a     illustrates flow charts of encoding and decoding methods according to embodiments;

Fig. 4b     illustrates the principle of shortening variable nodes;

Fig. 5     shows an example parity check matrix consisting of a plurality of component matrices;

Fig. 6     shows a parity check matrix of a tail-biting LDPC convolutional encoding rule, the parity check matrix having $L^2$ component matrices;

Fig. 7     illustrates an embodiment of an encoder;

Fig. 8     shows a minimum $\alpha(T)$ required for the reliable communication of tail-biting spatially-coupled LDPC with $d_v$=4, $d_c$=20, L=32 and $\mu$ =3 when the transmission is over a binary erasure channel with $\varepsilon = \varepsilon_{map} \approx 0.1971$;

Fig. 9     illustrates the rate of spatially-coupled codes for a given ($\alpha(T)$, $T$). Over a large range of $T$, the rate exceeds the rate of the conventional spatially-coupled code;

Fig. 10     shows an example of a copy-and-permute operation for a protograph-based LDPC code using a protomatrix **B**;

Fig. 11     shows a visualization of a parity check matrix **H** obtained by lifting of the lifting matrix **A** obtained from the protograph shown in Fig. 3;

Fig. 12     illustrates protograph-based Code Design for tail-biting spatially-coupled codes, corresponding protograph matrix **B**;

Fig. 13a     illustrates a protograph with shortened variable nodes; and

Fig. 13b    shows the protograph of Fig. 13a where the shortened variable nodes are removed as they are not transmitted, simplifying the graph.

Description of Embodiments

Various example embodiments will now be described more fully with reference to the accompanying drawings in which some example embodiments are illustrated. In the figures, the thicknesses of lines, layers and/or regions may be exaggerated for clarity.

Accordingly, while example embodiments are capable of various modifications and alternative forms, embodiments thereof are shown by way of example in the figures and will herein be described in detail. It should be understood, however, that there is no intent to limit example embodiments to the particular forms disclosed, but on the contrary, example embodiments are to cover all modifications, equivalents, and alternatives falling within the scope of the present disclosure. Like numbers refer to like or similar elements throughout the description of the figures.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between," "adjacent" versus "directly adjacent," etc.).

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, integers, steps, operations, elements and/or components, but do not preclude the presence or addition of one or more other features, integers, steps, operations, elements, components and/or groups thereof.

Unless otherwise defined, all terms (including technical and scientific terms) used herein have the same meaning as commonly understood by one of ordinary skill in the art to which example embodiments belong. It will be further understood that terms, e.g., those defined in commonly used dictionaries, should be interpreted as having a meaning that is consistent with their meaning in the context of the relevant art. However, should the present disclosure give a specific meaning to a term deviating from a meaning commonly understood by one of ordinary skill, this meaning is to be taken into account in the specific context this definition is given herein.

For a better understanding of embodiments, a short introduction to LDPC codes and some related decoding algorithms will be provided in the following.

An LDPC code may be defined by a sparse parity-check matrix $H$ of dimension $M \times N$, where $N$ is the code word length (e.g., in bits) of the LDPC code and $M$ denotes the number of parity bits or equations. The rows of a parity check matrix are parity equations on the code words of a code. That is, they determine how linear combinations of certain digits of each code word equal zero. Usually, the number of information bits equals $N$-$M$ (but can be larger, depending on the rank of the parity-check matrix $H$). The design rate of the code amounts to $r = (N$-$M)/N$. The overhead of the code is defined as OH = $1/r$ - 1 = $M/(N$-$M)$. Sparse means that the number of 1s in $H$ is small compared to the number of zero entries. Practical LDPC codes usually have a fraction of "Is" that is below 1%.

We start by introducing some notation and terminology related to LDPC codes. Each column of the parity check matrix $H$ corresponds to one symbol (e.g. a bit) of a Forward Error Correction (FEC) frame or LPDC code word. As LDPC codes can also be represented in a graphical structure called Tanner graph, the columns of $H$ and thus the FEC frame (LPDC code word) symbols are sometimes also referred to as variable nodes, referring to the graph-theoretic representation. Similarly, each row of $H$ corresponds to a parity check equation and ideally defines a parity symbol (e.g., a parity bit), if $H$ has full rank. For example, the rank can be defined as the column rank. The column rank of a matrix $H$ is the maximum number of linearly independent column vectors of $H$. Correspondingly, the row rank of $H$ is the maximum number of linearly independent row vectors of $H$. Owing to the Tanner graph representation, the rows of $H$ are associated to so-called check nodes, and the columns of $H$ are associated to so-called variable nodes. Further, the $M$ rows of $H$ specify $M$ check node connections, and the $N$ columns of $H$ specify $N$ variable node connections. Thereby, check node $i$ is connected to variable node $j$ whenever element $H_{i,j}$ in $H$ is different from zero. Note that the row rank and the column rank of a matrix $H$ are always equal, which is a well-known result in linear algebra.

In order to describe an exemplary LDPC decoder we introduce some additional notation. First, we denote by $\mathbf{x}$ a vector of $K = N - M$ information symbols. The single elements of $\mathbf{x}$ are denoted by $x_i$, i.e., $\mathbf{x} = (x_1, x_2, ..., x_i, ..., x_K)^T$. After encoding with an exemplary LDPC encoder, an LDPC code word $\mathbf{y} = (y_1, y_2, ..., y_N)^T$ of length $N$ results. We denote by $y_i$ the single elements of the code word $\mathbf{y}$. The LDPC code is said to be systematic if the information vector $\mathbf{x}$ is included in the code word, e.g., if (after possible rearrangement) $\mathbf{y} = (x_1, ..., x_K, p_1, ... p_M)^T$, with $\mathbf{p} = (p_1, ..., p_M)^T$ denoting the vector of $M$ parity symbols. Furthermore, let the set $\mathcal{N}(m)$ denote the positions of the 1s in the $m$-th row of **H**, i.e., $\mathcal{N}(m) = \{i: H_{m,i} = 1\}$. A binary vector **y** is a code word of the LDPC code defined by **H**, if **Hy = 0**, with the additions defined over the binary field (addition modulo-2, or XOR, respectively), for example. The set of code words is thus defined to be the null space of **H**. This signifies that the product of each row of **H** and **y** is zero, or $\sum_{j \in \mathcal{N}(m)} y_j = 0$, for all $m$ with $1 \leq m \leq M$.

Let us illustrate the concept of LDPC codes by a "toy" example. This example defines a binary parity check matrix **H** of two concatenated (4, 5) single parity check codes, separated by a 4x5 block-interleaver. The exemplary parity check matrix **H** of dimension 9x25 is given by

$$
\mathbf{H} = \begin{pmatrix}
1 & 1 & 1 & 1 & & & & & & & & & & & & & 1 & & & & & & & & \\
& & & & 1 & 1 & 1 & 1 & & & & & & & & & & 1 & & & & & & & \\
& & & & & & & & 1 & 1 & 1 & 1 & & & & & & & 1 & & & & & & \\
& & & & & & & & & & & & 1 & 1 & 1 & 1 & & & & 1 & & & & & \\
1 & & & & & & & 1 & & & & & 1 & & & & & 1 & & & & 1 & & & \\
& 1 & & & & 1 & & & & 1 & & & & 1 & & & & & & & & 1 & & & \\
& & 1 & & & & 1 & & & & 1 & & & & 1 & & & & & & & & 1 & & \\
& & & 1 & & & & 1 & & & & 1 & & & & 1 & & & & & & & & 1 & \\
& & & & & & & & & & & & & & & & 1 & 1 & 1 & 1 & & & & & 1
\end{pmatrix}.
$$

Note that for simplicity reasons only the 1s are illustrated in the parity check matrix H above. Thus, M= 9, $N$ = 25, and the code has an overhead of 56% (given by $M/(N - M)$) or a rate of $r = 0.64$, equivalently. We have

$\mathcal{N}(1) = \{1; 2; 3; 4; 17\}$, $\mathcal{N}(2) = \{5; 6; 7; 8; 18\}$, $\mathcal{N}(3) = \{9; 10; 11; 12; 19\}$, $\mathcal{N}(4) = \{13; 14; 15; 16; 20\}$, $\mathcal{N}(5) = \{1; 5; 9; 13; 21\}$, $\mathcal{N}(6) = \{2; 6; 10; 14; 22\}$, $\mathcal{N}(7) = \{3; 7; 11; 15; 23\}$, $\mathcal{N}(8) = \{4; 8; 12; 16; 24\}$, $\mathcal{N}(9) = \{17; 18; 19; 20; 25\}$. This means for instance that we have (using the first row of H) $y_1+y_2+y_3+y_4+y_{17}=0$, or, if the code is systematic, $x_1+x_2+x_3+x_4+p_1=0$, *i.e.*, $p_1=x_1+x_2+x_3+x_4$, defines the first parity bit.

One common decoding algorithm for LDPC codes is the so-called "sum-product" decoding algorithm and its simplified versions. These algorithms can be described either in a graph structure commonly denoted Tanner graph, or given directly in a form suitable for implementation. While the former is advantageous for describing and understanding the underlying operations, we focus on the latter.

In the context of coherent detection, we can usually assume an equivalent Additive White Gaussian Noise (AWGN) channel model for the transmission channel. This assumption is justified by the central limit theorem which applies due to the extensive use of filtering in inner Digital Signal Processing (DSP) stages of a transmitter and/or receiver. If we denote by $y_i(i = 1, ..., N)$ the single bits of an LDPC code word **y** as defined above, then the received values at the input of an LDPC decoder amount to $z_i = y_i + n_i$, with $n_i(i = 1, ..., N)$ being Gaussian distributed noise samples of zero mean and variance $\sigma^2$. Usually, the received noisy samples are converted into the Log-Likelihood Ratio (LLR) domain, which leads to a numerically more stable decoder implementation. The LLR of a received sample $z_i$ may be defined as

$$
L(z_i) = \log\left(\frac{p(z_i \mid y_i = 0)}{p(z_i \mid y_i = 1)}\right) \tag{1}
$$

with $p(z_i \mid y_i = k) = \exp\left(-(z_i - (1-2k))^2 / (2\sigma^2)\right) / \sqrt{2\pi\sigma^2}$ denoting the probability density function (pdf) of the received sample $z_i$ under AWGN assumption conditioned on the transmitted bit $y_i$ and with bipolar signaling ($y_i=0 \rightarrow +1$, $y_i=1 \rightarrow -1$). Conveniently, it turns out that $L(z_i) = z_i \cdot 2/\sigma^2 = z_i \cdot L_c$ under the AWGN assumption. Usually, the value $L_c = 2/\sigma^2$ is assumed to be constant and predetermined.

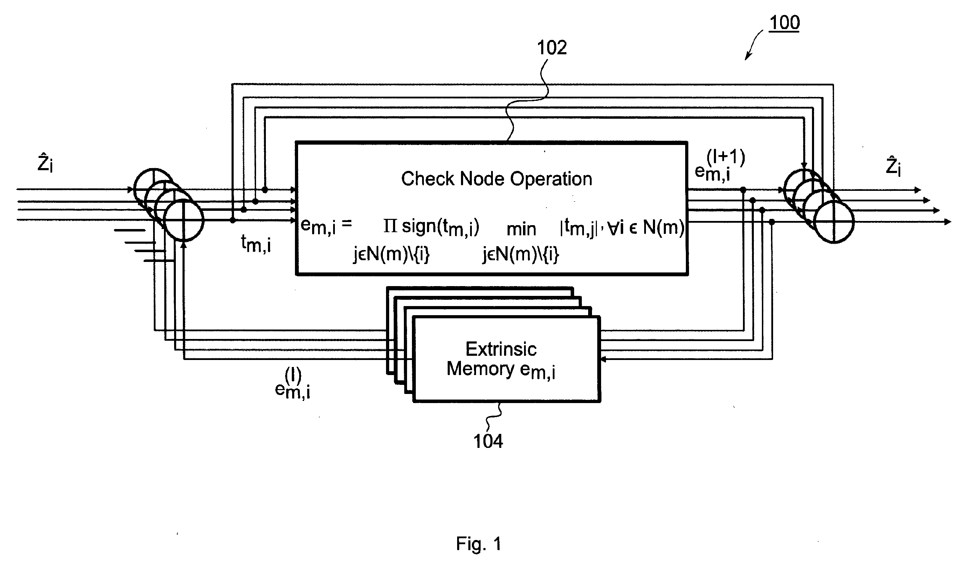

Turning now to **Fig. 1**, we describe a conventional row-layered LDPC decoding algorithm. Here, an LDPC decoder 100 continuously updates the received LLR values with the goal to compute LLRs that approximate the Maximum A-Posteriori (MAP) values. The received vector of LLRs $z$ is therefore copied to a memory $z$ of size $N$, which is continuously updated. This memory maybe referred to as LLR memory, a-posteriori memory or reliability information memory in later sections of this specification. The decoding operation in the row-layered decoder 100 comprises three acts, where a) the first act prepares the input data, b) the second act performs the computation of new extrinsic data and act c) updates the LLR memory. The row-layered LDPC decoder 100 may carry out the three steps sequentially for each row of the parity check matrix **H**. After all rows have been considered, a single decoding iteration has been carried out. The LDPC decoder 100 usually carries out several iterations, where the number depends on the available resources.

In the following, we describe the aforementioned three acts for a single row $m$ of **H**. The first step a) comprises computing $\mathrm{card}(\mathcal{N}(m)) = d_c$ (card = cardinality) temporary values $t_{m,i}$, with

$$t_{m,i} = \hat{z}_i - e_{m,i}^{(l)} \qquad \text{for all } i \in \mathcal{N}(m) \tag{2}$$

for all non-zero entries (indexed by $i$) of the $m$'th row of **H**. The superscript $^{(l)}$ denotes the iteration counter, i.e., the operations are carried out in the $l$-th iteration of the row-layered LDPC decoding procedure. The value $e_{m,i}$ is the (stored) extrinsic memory for row $m$ and variable $\hat{z}_i$. At the beginning of the decoding of a single LDPC frame (code word), all $e_{m,i}$ may be initialized by zero (i.e., $e_{m,i}^{(1)} = 0$) and then continuously updated. Note that in total only $\sum_m \mathrm{card}(\mathcal{N}(m))$ memory locations may be used for storing the $e_{m,i}$. If the code is check-regular, $\sum_m \mathrm{card}(\mathcal{N}(m)) = M \cdot d_c$. In the second step, the extrinsic memory 104 for the subsequent iteration ($l$+1) may be updated using the $t_{m,i}$ according to

$$e_{m,i}^{(l+1)} = 2 \cdot \tanh^{-1}\left( \prod_{j \in \mathcal{N}(m)\backslash\{i\}} \tanh\left(\frac{t_{m,j}}{2}\right) \right) \qquad \text{for all } i \in \mathcal{N}(m)$$

$$= \left[ \prod_{j \in \mathcal{N}(m)\backslash\{i\}} \mathrm{sign}(t_{m,j}) \right] \cdot \phi\left( \sum_{j \in \mathcal{N}(m)\backslash\{i\}} \phi(|t_{m,j}|) \right), \quad \text{with} \quad \phi(\tau) = -\log\left( \tanh\left(\frac{\tau}{2}\right) \right) = \log\left(\frac{e^\tau + 1}{e^\tau - 1}\right) \tag{3}$$

where the log-domain expression of the Sum-Product Algorithm (SPA) according to equation (3) may be more suitable for practical implementations, as the multiplication is replaced by an addition and instead of two functions $\tanh(\cdot)/\tanh^{-1}(\cdot)$, only a single function $\phi(\cdot)$ needs to be implemented (or approximated by a look-up table). The product (or the sum) of equation (3) may be carried out over all entries in $\mathcal{N}(m)$ except the one under consideration $i$. This is indicated by the notation $\mathcal{N}(m)\backslash\{i\}$. For instance, in the above example, where $\mathcal{N}(5) = \{1; 5; 9; 13; 21\}$, $e_{5,13}^{(l+1)}$ may be computed corresponding to

$$e_{5,13}^{(l+1)} = 2 \cdot \tanh^{-1}\left( \prod_{j \in \mathcal{N}(5)\backslash\{13\}} \tanh\left(\frac{t_{m,j}}{2}\right) \right) = 2 \cdot \tanh^{-1}\left( \prod_{j \in \{1;5;9;21\}} \tanh\left(\frac{t_{m,j}}{2}\right) \right)$$

$$= 2 \cdot \tanh^{-1}\left( \tanh\left(\frac{t_{5,1}}{2}\right) \tanh\left(\frac{t_{5,5}}{2}\right) \tanh\left(\frac{t_{5,9}}{2}\right) \tanh\left(\frac{t_{5,21}}{2}\right) \right). \tag{4}$$

The derivation of equation (4) for the extrinsic update is beyond the scope of this specification. Usually, if high LDPC decoder throughputs shall be achieved, the computation of $e_{m,i}$ can be further simplified. An often employed simplification of the SPA log-domain equation (3), which we will consider in the following, is the so-called min-sum approximation or min-sum algorithm which leads to

$$e_{m,i}^{(l+1)} = \left[ \prod_{j \in \mathcal{N}(m)\backslash\{i\}} \text{sign}(t_{k,j}) \right] \min_{j \in \mathcal{N}(m)\backslash\{i\}} |t_{m,j}| \qquad \text{for all } i \in \mathcal{N}(m). \qquad (5)$$

As the second act b) computes the output of the parity check node $m$ of the check node in the graphical representation of LDPC codes, it is frequently denoted by check node operation 102. Hence, equation (5) may be denoted as min-sum check-node update operation having reduced complexity vis-à-vis the SPA check-node update operations of equation (3).

In the next decoding act c), the LLR memory may be updated corresponding to

$$\hat{z}_i = t_{m,i} + e_{m,i}^{(l+1)} \qquad \text{for all } i \in \mathcal{N}(m) \qquad (6)$$

and the LDPC decoder 100 may continue with decoding row $m+1$ or, if $m = M$, restarts at $m = 1$ (next iteration, $l + 1$).

Fig. 1 shows the simplified block diagram 100 of the min-sum check-node update operation for computing $e_{m,i}^{(l+1)}$

according to equation 5 for $\text{card}(\mathcal{N}(m)) = 4$ (i.e., **H** contains for 1s at row $m$). As has been explained before, the check node operation 102 may be realized by equations (3) (log-domain SPA) or (5) (min-sum domain). Note that a routing network to access the different $\hat{z}_i$ (which are not necessarily stored in neighboring memory locations) is not shown in the Fig. 1.

The second step b), i.e., the check-node update, can be further simplified in actual implementations. Let

$\mu_m^{[1]} = \min\limits_{j \in \mathcal{N}(m)} |t_{m,j}|$ be the first minimum of the absolute value of all involved incoming messages $t_{m,j}$ at row $m$ and let

$i_m^{[1]} = \arg \min\limits_{j \in \mathcal{N}(m)} |t_{m,j}|$ be the position (i.e., the index) of this first minimum. Let furthermore $\mu_m^{[2]} = \min\limits_{j \in \mathcal{N}(m)\backslash\{i_m^{[1]}\}} |t_{m,j}|$ be the second minimum (larger than the first minimum) of all incoming messages at row $m$. We further define

$s_m = \prod\limits_{j \in \mathcal{N}(m)} \text{sign}(t_{m,j})$. The output message can then be computed corresponding to

$$e_{m,i}^{(l+1)} = s_m \cdot \text{sign}(t_{m,i}) \cdot \begin{cases} \mu_m^{[1]} & \text{if } i \neq i_m^{[1]} \\ \mu_m^{[2]} & \text{if } i = i_m^{[1]} \end{cases} \qquad (7)$$

Note that equation (7) is an alternative representation of the min-sum check-node update operation of equation (5). Thus, one burden for implementing the check node operation 102 for computing $e_{m,i}^{(l+1)}$ consists in finding the first and second minimum of the incoming messages together with the position of the first minimum. The memory requirements of this algorithm are $N$ memory cells for storing the (continuously updated) a-posteriori values $\hat{z}_i$. Additionally, the storing requirements of the extrinsic memory $e_{m,i}$ 104 amount to the total number of 1s in the parity check matrix **H**, however, due to the simplified implementation using the minimum approximation, the extrinsic memory 104 does not need to store all $d_c$ different values per row, but only the $d_c$ different signs, both minima $\mu_m^{[1]}$ and $\mu_m^{[2]}$, and the location index of the first minimum $i_m^{[1]}$. The values $e_{m,i}$ can then be computed on the fly as required.

As the min-sum algorithm according to equation (5) is only an approximation to the full belief-propagation expression of equation (3), numerous attempts have been made to improve the performance of the min-sum algorithm, i.e., the min-sum check-node update operation. One notable improvement is the so-called offset min-sum algorithm. The check-node update rule of the offset min-sum algorithm reads

$$e_{m,i}^{(l+1)} = s_m \cdot \text{sign}(t_{m,i}) \cdot \begin{cases} \max(\mu_m^{[1]} - \beta, 0) & \text{if } i \neq i_m^{[1]} \\ \max(\mu_m^{[2]} - \beta, 0) & \text{if } i = i_m^{[1]} \end{cases}, \qquad (8)$$

where the offset correction variable $\beta$ can either be constant and determined offline or be updated during decoding according to a predefined rule.

While in the 1960s and the following decades, most coding research focused on block coding techniques, many practical coding schemes were based upon convolutional codes. With the advent of turbo codes and the rediscovery of LDPC codes, this suddenly changed such that nowadays most new coding schemes are again block codes. The trend is, however, to return back to convolutional-like structures.

In the last few years, the class of spatially coupled code ensembles has emerged and has shown to have appealing properties. LDPC convolutional codes, which are one particular instance of spatially coupled codes, have been around for more than a decade, but only recently it has been noticed that the belief propagation thresholds of certain (terminated) protograph-based LDPC convolutional codes approach the MAP thresholds of the underlying ensemble in the limit of the code word length.

This effect of threshold saturation by introducing structure has been analyzed for the Binary Erasure Channel (BEC) and it has been shown that spatially coupled LDPC codes can asymptotically achieve the MAP threshold of the underlying regular ensemble under belief propagation decoding. Recently, this result has been extended to more general channels and it has been shown that spatially coupled ensembles universally achieve the capacity over binary-input memoryless symmetric-output channels: most codes of this ensemble are good for each channel realization of this class of channels.

Instead of being a block code of dimension $N$ with parity-check matrix $\mathbf{H}$, an LDPC convolutional code has an infinitely extended parity-check matrix $\mathbf{H}_{conv}$, which has the following form

$$
H = \begin{pmatrix}
\ddots & & & & & & & \\
\ddots & H_0(0) & & & & & & \\
 & H_1(1) & H_0(1) & & & & & \\
\ddots & \vdots & H_1(2) & & & & & \\
 & H_\mu(\mu) & \vdots & \ddots & & & & \\
 & & H_\mu(\mu+1) & \ddots & & & & \\
 & & & & H_0(t) & & & \\
 & & & \ddots & H_1(t+1) & \ddots & & \\
 & & & & \vdots & \ddots & & \\
 & & & & H_\mu(t+\mu) & & & \\
 & & & & & & \ddots &
\end{pmatrix}_\infty .
$$

Note that for simplicity reasons only the non-zero component matrices are illustrated in the parity check matrix $\mathbf{H}$ above. Here, the value $\mu$ is commonly called the syndrome former memory, in analogy to convolutional codes. Conventionally, $\dim(\mathbf{H}_0) = \dim(\mathbf{H}_1) = M \times N$ holds. The above parity-check matrix of LDPC convolutional codes may be defined conveniently by a so-called row-defining matrix, which may be given by (in the most general case) component matrices

$$
\mathbf{H}_{row}(t) = \begin{pmatrix} \mathbf{H}_\mu(t) & \cdots & \mathbf{H}_1(t) & \mathbf{H}_0(t) \end{pmatrix},
$$

with $\dim \mathbf{H}_{row}(t) = M \times (\mu+1)N$. The parity-check matrix $\mathbf{H}_{conv}$ of the convolutional LDPC code can be obtained by placing stacked copies of $\mathbf{H}_{row}(t)$ (with adapted time indices) that overlap by $\mu N$ columns. Time-independent LDPC convolutional codes may be constructed by a time-independent row-defining matrix $\mathbf{H}_{row}(t) = \mathbf{H}_{row}$.

In the exemplary time independent case of $\mu = 1$ the parity check matrix H can be written as

$$\mathbf{H}_{conv} = \begin{pmatrix} \ddots & & & & \\ \ddots & \mathbf{H}_0 & & & \\ & \mathbf{H}_1 & \mathbf{H}_0 & & \\ & & \mathbf{H}_1 & \mathbf{H}_0 & \\ & & & \mathbf{H}_1 & \ddots \\ & & & & \ddots \end{pmatrix}_{\infty} .$$

Usually, the trigger of the decoding wave is performed using so-called termination. This termination induces a certain rate loss, which is a function of the total length of the code and the construction. Starting from the above infinitely extended parity-check matrix of the spatially coupled code we may construct a terminated matrix by just cutting a portion consisting of *L* blocks of the above matrix leading to

$$\boldsymbol{H} = \begin{pmatrix} \boldsymbol{H}_0(0) & & & & \\ \boldsymbol{H}_1(1) & \boldsymbol{H}_0(1) & & & \\ \vdots & \boldsymbol{H}_1(2) & & & \\ \boldsymbol{H}_\mu(\mu) & \vdots & \ddots & & \\ & \boldsymbol{H}_\mu(\mu+1) & \ddots & & \\ & & & \boldsymbol{H}_0(t) & \\ & & \ddots & \boldsymbol{H}_1(t+1) & \\ & & & \vdots & \\ & & & \boldsymbol{H}_\mu(t+\mu) \end{pmatrix} .$$

The size of the above matrix may be $(L + \mu)M \times LN$. The rate of this terminated code is $R_L = R - \dfrac{\mu M}{LN}$, where R denotes the rate of the original unterminated code. We see that the original rate R is decreased by a factor $\mu M/LN$. If *L* increases, this factor becomes smaller, however in real systems, often a finite *L* may be assumed to account for, e.g., block structures and to achieve a good overall performance.

Again, in the exemplary time independent case and $\mu = 1$ the above parity check matrix **H** can be written as

$$\mathbf{H}_{conv} = \begin{pmatrix} \mathbf{H}_0 & & & & \\ \mathbf{H}_1 & \mathbf{H}_0 & & & \\ & \mathbf{H}_1 & \ddots & & \\ & & \ddots & \mathbf{H}_0 & \\ & & & \mathbf{H}_1 & \mathbf{H}_0 \\ & & & & \mathbf{H}_1 & \ddots \\ & & & & & \ddots \end{pmatrix}_{\infty} .$$

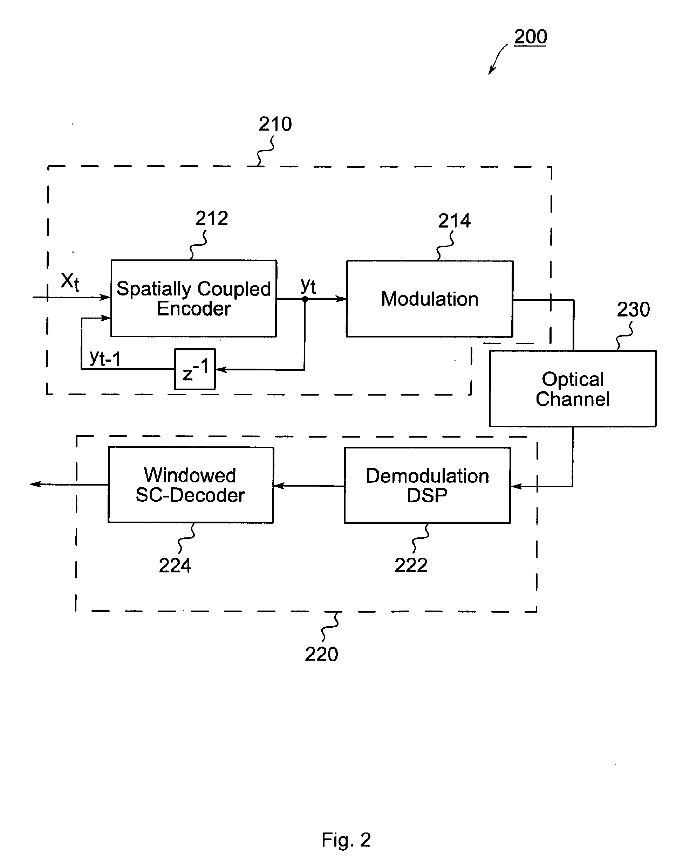

An example encoder 212 for the LDPC convolutional code with $\mu = 1$ and parity check matrix $\mathbf{H}_{conv}$ is illustrated in the system model 200 of **Fig.** 2. Note however that embodiment are not limited to $\mu = 1$, but can be extended to arbitrary syndrome former memories.

The system model 200 comprises an optical transmitter 210 and receiver 220 connected via an optical channel 230, such as a fiber, for example. The optical communication channel 230 may also comprise additional inner digital signal processing stages, such as equalization, dispersion compensation, MIMO processing, phase offset estimation and correction, frequency offset estimation and correction, etc. The skilled person having benefit from the present disclosure will also appreciate that embodiments are not restricted to optical communication systems, but may also employed in other wired or wireless communication systems.

The LDPC convolutional encoder 212 encodes a block of input bits $\mathbf{x}_t$ (note that we include time indices to stress the dependence on previous frames) using $\mathbf{H}_0$ and $\mathbf{H}_1$ together with a previously encoded block $\mathbf{y}_{t-1}$ yielding $\mathbf{y}_t$. The size of each $\mathbf{y}_t$ amounts $N$, with $\dim(\mathbf{H}_0)=\dim(\mathbf{H}_1) = M \times N$. As $\mathbf{H}_0$ usually has a simple structure with a single identity matrix on the right hand part, encoding may be rather trivial: each parity bit (with the position of the parity bit corresponding to the positions of the identity matrix) may be directly given from the input bits $\mathbf{x}_t$ and the bits of the previously encoded block $\mathbf{y}_{t-1}$. We define $\mathbf{H}_0 = [\mathbf{H}_{0,s}\ \mathbf{I}]$ with I denoting the identity matrix and we define the sets

$$\mathcal{N}_1(m) = \{i : H_{1,m,i} \neq 0\}$$

$$\mathcal{N}_{0,s}(m) = \{i : H_{0,s,m,i} \neq 0\}$$

that contain the positions of the non-zero entries of $\mathbf{H}_0$ and $\mathbf{H}_{1,s}$ for row $m$, respectively. Let $\mathcal{N}_{1,i}(m)$ denote the $i$'th entry of $\mathcal{N}_1(m)$ and $\mathcal{N}_{0,s,i}(m)$ the $i$'th entry of $\mathcal{N}_{0,s}(m)$. The generation of parity bit $p_m$ ($1 \leq m \leq M$) can be described by

$$p_m \equiv \sum_i H_{1,m,\mathcal{N}_{1,i}(m)} y_{t-1,\mathcal{N}_{1,i}(m)} + \sum_j H_{0,s,m,\mathcal{N}_{0,s,j}(m)} x_{t,\mathcal{N}_{0,s,j}(m)} \mod 2 .$$

Note that in principle every parity bit can be computed in parallel. At least S parity bits can be computed in parallel by fetching blocks of S data bits and respective shifter circuits. Here, S corresponds to a so-called lifting factor, which will be described in more detail below.

The encoded block or frame $\mathbf{y}_t$ may be modulated using a modulator 214 to yield a block of modulated transmit symbols. The modulated transmit symbols are then transmitted to the receiver 220 via the communication channel 230, which may be an optical communication channel in some embodiments. A demodulator 222 may extract reliability information, e.g. LLRs, for each symbol or bit of a received encoded block or frame.

Spatially coupled or LDPC convolutional codes may be decoded using a sliding windowed decoder 224 to recover the information sequences. The decoder 224 may operate on a window of w copies of the row defining matrix $\mathbf{H}_{row}$ corresponding to a window of $(w+\mu)$ frames of reliability information. For faster convergence speed, the windowed decoding can be combined with the aforementioned row-decoding or layered decoding algorithm. Note that example embodiments are not limited to the use of the layered decoding scheme but also other decoding schemes may be employed, which do not use an explicit a-posteriori memory. For example, a conventional flooding decoder does not need an a-posteriori memory, but rather needs extrinsic edge memories that play a similar role. The layered decoder continuously updates and refines the received reliability information (e.g. LLR values) in the decoding window with the goal to compute LLRs that approximate the MAP values.

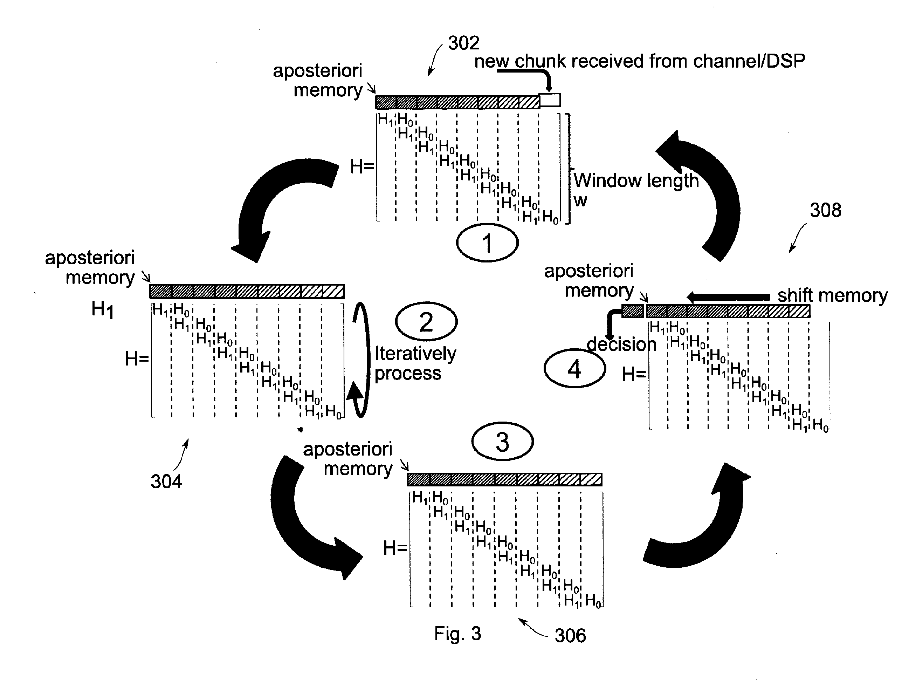

Four exemplary cycles of the windowed decoder 224 are depicted in **Fig. 3** for an example with window size w = 8. The example windowed decoder 224 makes use of an a-posteriori memory of size $(w+\mu)N$, with $N$ = columns($\mathbf{H}_0$) = columns($\mathbf{H}_1$) = $N''SP$.

In a first act 302 of the illustrated cycle a new chunk or frame (size $N$) of received reliability information, e.g. LLRs, at time instant $t$ is received and inserted into an appropriate position (for example an input portion) of an a-posteriori memory of the decoder 224. In a second act 304, a predefined number $V$ of layered decoder iterations may be executed making use of the row defining matrix $\mathbf{H}_{row}$. Note that the row decoder algorithm can be designed for this matrix $\mathbf{H}_{row}$ and then can be reused by just accessing appropriately shifted memory locations. In case of the windowed decoder 224 the previously described decoding algorithms may be applied to the whole reliability information window as LLR memory in a straight-forward fashion.

The different shades of grey in a third act 306 (as well as in the other steps) indicate reliabilities of different frames of received LLRs in the decoders's a-posteriori memory. It can be observed that the reliabilities increase from right to left, i.e., the oldest values having received the highest number of updates, have the largest reliability. In a fourth act 308 of the cycle, the decoder's a-posteriori memory is shifted and the left-most LLR frame (for example in an output portion of the a-posteriori memory) may be forwarded to a hard decision circuit in order to recover hypothetically transmitted symbols. After the shifting, there is now room for a new frame that can be inserted into the input portion in the first act 302 of the next cycle.

Note that the version of the windowed decoding algorithm described above introduces a decoding delay of $w+\mu\text{-}1$ frames, such that at time instant $t$, we can recover the information frame $\mathbf{x'}_{t\text{-}w\text{-}\mu\text{+}1}$. This is however of no issue in an optical communication system operating in a streaming fashion. Note that at the beginning an LDPC convolutional like encoder may be initialized with zeros at its input dedicated to the delayed version $\mathbf{y}_{t\text{-}1}$ of the encoded output signal $\mathbf{y}_t$ in the case where the code has been terminated. Hence, in the case of LDPC convolutional encoders the two inputs to the encoder at time instant $t$ may be an input signal $\mathbf{x}_t$ (to be encoded) as well as the delayed (encoded) output signal $\mathbf{y}_{t\text{-}1}$ (and, if $\mu > 1$, $\mathbf{y}_{t\text{-}1}$, ..., $\mathbf{y}_{t\text{-}\mu}$). If the transmission starts at $t = 0$, this means that we set $\mathbf{y}_{\text{-}1} = \mathbf{0}$. Accordingly, the memory of the decoder 224 may be initialized with perfect knowledge about the initial symbols being zero (LLR equals $+\infty$ or the corresponding maximum value in the case of a fixed point implementation). Usually, after a certain amount of frames denoted by $L$ (i.e., at $t = L$), the transmission may be reset to prevent error propagation and the decoder/encoder pair is brought into the initial stage again. Note that this termination may lead to an unavoidable rate loss but is crucial for the outstanding performance of spatially coupled codes. If the code is not terminated, e.g., if a tail-biting code is used, the decoder memory may be initialized with a previously received chunks corresponding to a contiguous sequence of $w+\mu\text{-}1$ chunks out of the total $L$ chunks when the next chunk that enters the decoder in the first cycle 302 corresponds to the next chunk in that mentioned sequence.

In order to improve the code rate of conventional terminated LDPC convolutional codes embodiments of the present disclosure propose shortening some positions in certain portions of a codeword, such that the rate loss is at least reduced and the decoding wave is still triggered. For this it is suggested to take a terminated LDPC convolutional code with $L$ positions, e.g., $L$ component matrices per row of the associated terminated parity check matrix, and pick $T$ < $L$ positions within the code. Thereby each such position $t$ comprises one block of component matrices $\mathbf{H}_l(t)$ ($l = 0, ... ,\mu$) in the above description. At each position we shorten a portion of the associated code bits. For example, associated code bits may be set to zero and are not transmitted. Note that we also consider a whole respective column of the matrix when shortening.

Embodiments of the present disclosure lead to LDPC convolutional codes which may be described by spatially coupled bipartite graph components (such as Tanner graphs) corresponding to the aforementioned component matrices, wherein not all bipartite graph components have the same number of variable nodes. Some bipartite graph components - so-called shortened bipartite graph components - have a reduced number of variable nodes compared to other bipartite graph components - so-called non-shortened bipartite graph components. Thereby, shortened bipartite graph components may be represented by so-called shortened component matrices, while non-shortened bipartite graph components may be represented by so-called non-shortened component matrices of a parity check matrix. In line with the explanation above, shortened component matrices have fewer columns compared to non-shortened component matrices.

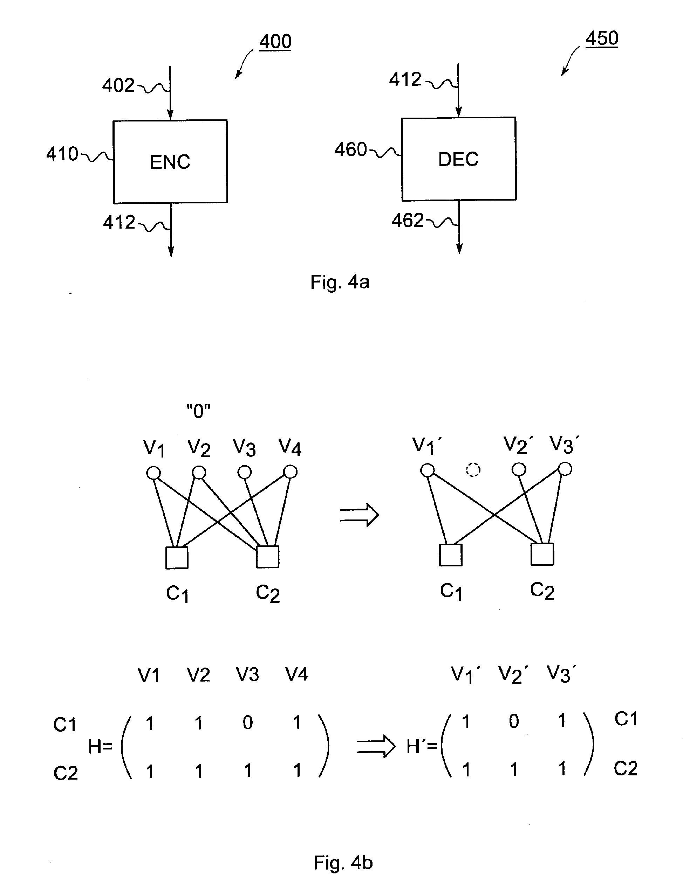

Turning now to **Fig. 4a,** it is shown a flow chart of a method 400 for encoding a signal 402 according to a general embodiment. The skilled person will appreciate that method 400 may be performed by embodiments of the LDPC convolutional encoder 212 of system 200, for example.

Method 400 includes an act 410 of encoding the signal 402 based on an LDPC convolutional encoding rule ENC to obtain an encoded signal 412, i.e. one or more codewords. The LDPC convolutional encoding rule ENC may be defined by a parity check matrix having a number of component matrices. The component matrices include zero and non-zero component matrices. Each non-zero component matrix corresponds to a parity check matrix of a component LDPC block code. Further, the component matrices of the parity check matrix defining the LDPC convolutional encoding rule ENC comprise so-called shortened component matrices and non-shortened component matrices. Here, a shortened non-zero component matrix represents a bipartite graph, e.g. a Tanner graph, with fewer variable nodes than a non-shortened (and non-zero) component matrix. Alternatively, a shortened component matrix has fewer columns than a non-shortened component matrix. At the same time, a shortened component matrix has the same number of rows as a non-shortened component matrix.

Fig. 4a also illustrates a flow chart of a method 450 for decoding the encoded signal 412. The decoding method comprises an act 460 of decoding the encoded signal 412 based on an LDPC convolutional decoding rule DEC to obtain a decoded signal 462. The LDPC convolutional decoding rule DEC may be defined by a parity check matrix having a number of component matrices. The component matrices include zero and non-zero component matrices. Each non-zero component matrix corresponds to a parity check matrix of a component LDPC block code. Further, the component matrices of the parity check matrix defining the LDPC convolutional decoding rule DEC comprise shortened component matrices and non-shortened component matrices.

A possibility of "shortening" the effective bipartite graph together with its associated parity check matrix defining the LDPC convolutional encoding and decoding rules ENC, DEC is explained referring to **Fig. 4b.**

The left side of Fig. 4b illustrates an exemplary Tanner graph (component) having four variable nodes $v_1$, $v_2$, $v_3$, $v_4$ and two check nodes $c_1$ and $c_2$. Below said Tanner graph it is illustrated the corresponding (component) parity check matrix **H.** If input and/or code bits associated with variable node $v_2$ are not unknown but predetermined, e.g. fixed to zero, the resulting effective Tanner graph and its corresponding (component) matrix **H'** are shown on the right of Fig.

4b. The original variable node $v_2$ can effectively be omitted, leading to remaining three effective variable nodes $v_1$', $v_2$', and $v_3$'. Consequently the effective (component) matrix **H'** describing the code has one column less than the original matrix **H**. That is to say, in some embodiments, shortened effective component matrices can be obtained by setting input bits and/or code bits (or symbols) associated with certain variable nodes to predetermined values, thereby effectively "muting" the associated variable node.

The skilled person will appreciate that the flow charts of Fig. 4a may also represent a block diagram of corresponding LDPC convolutional encoders/decoders.

In this context, reference numeral 400 may denote an apparatus for encoding the signal 402. The apparatus 400 includes an LDPC convolutional encoder 410 having an input for the signal 402 and an output for an encoded signal 412. The LDPC convolutional encoder 410 is configured to encode the signal 402 based on LDPC convolutional encoding rule ENC to obtain the encoded signal 412. The LDPC convolutional encoding rule ENC is defined by a parity check matrix having a plurality of component matrices including shortened component matrices and non-shortened component matrices. Likewise, reference numeral 450 may denote an apparatus for decoding the signal 412. The apparatus 450 includes an LDPC convolutional decoder 460 having an input for the signal 412 and an output for a decoded signal 462. The LDPC convolutional encoder 460 is configured to decode the signal 412 based on LDPC convolutional decoding rule DEC to obtain the decoded signal 462. The LDPC convolutional decoding rule DEC is defined by a parity check matrix having a plurality of component matrices including shortened component matrices and non-shortened component matrices.

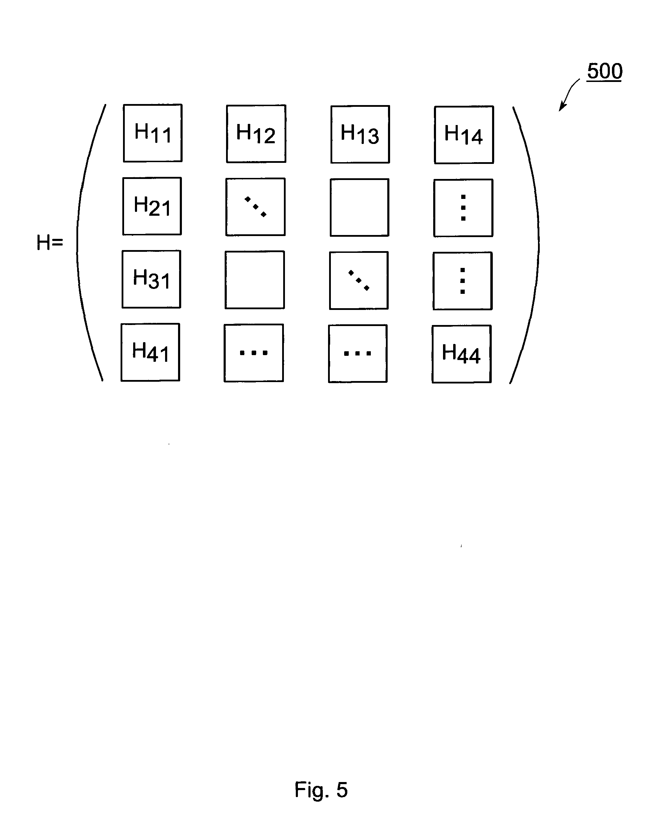

To further explain the role of the parity check matrix, **Fig. 5** shows an illustrative example of a parity check matrix **H** (reference numeral 500) defining an LDPC convolutional encoding rule according to an embodiment. In some embodiments, the parity check matrix **H** may correspond to a terminated LDPC convolutional code and may have $L^2$ ($L \in \mathbb{N}$) component (parity check) matrices, i.e., a row of the parity check matrix corresponds to $L$ component matrices and a column of the parity check matrix corresponds to $L$ component matrices. As will be seen below, the $L$ component matrices of a row or a column may include $L - (\mu + 1)$ zero-valued component matrices and $\mu + 1$ non-zero valued component matrices.

The illustrative parity check matrix **H** of Fig. 5 has $4^2 = 16$ component matrices $\mathbf{H}_{mn}$ ($m = 1, ..., 4$; $n = 1, ..., 4$). While some of the component matrices $\mathbf{H}_{mn}$ may be all zero matrices, others may be non-zero component matrices corresponding to an LDPC block code component. As explained above, some of the component matrices $\mathbf{H}_{mn}$ are shortened component matrices, while others are non-shortened component matrices. While a non-shortened component matrix has a dimension $(M \times N)$ in embodiments, a shortened component matrix has a dimension $(M \times (1 - \alpha)N)$. This is, a shortened component matrix corresponds to an effective (component) bipartite graph with $\alpha N$ muted variable nodes. In other words, a shortened component matrix can be expressed by less columns (corresponding to variable nodes) than a non-shortened component matrix. However, a shortened component matrix has the same number of rows (corresponding to check nodes) as a non-shortened component matrix. Note that always all non-zero matrices of one column, i.e., having the same value $n \in \{1,...,N\}$ should be shortened.

This property of the parity check matrix **H** defining the LDPC convolutional encoding rule, i.e., a shortened component matrix representing a bipartite graph with $(1-\alpha)N$ variable nodes and a non-shortened component matrix representing a bipartite graph with $N$ variable nodes, leads to the following effect: For each component matrix (i.e., for each "column" of component matrices) of the parity check matrix, a signal block of $k$ (uncoded) input bits may be received at the input of the LDPC convolutional encoder 210. At the output, $(1-\alpha)N$ code bits may be provided based on the block of $k$ input bits for each of the shortened component matrices. On the other hand, for each of the non-shortened component matrices $N$ code bits are provided based on the block of $k$ information bits. As will become apparent further below, a signal block of $k$ input bits associated with an effectively shortened component (parity check) matrix may comprise less (unknown) information bits than a signal block of $k$ input bits associated with a non-shortened component matrix.

In preferred embodiments, each column of $L$ component matrices of the parity check matrix **H** may have the same number of non-zero component matrices as each row of $L$ component matrices of the parity check matrix **H.** This can be achieved, for example, if the parity check matrix **H** corresponds to a tail-biting LDPC convolutional encoding rule. Thereby tail-biting convolutional coding is a technique of trellis termination which avoids the rate loss incurred by zero-tail termination at the expense of a more complex decoder. In the most general tail-biting case, the parity check matrix **H** of the LDPC convolutional encoding rule may have the form

$$H = \begin{pmatrix} H_0(0) & & & & H_\mu(0) & \cdots & H_1(0) \\ H_1(1) & H_0(1) & & & & \ddots & \vdots \\ \vdots & H_1(2) & & & & & H_\mu(\mu-1) \\ H_\mu(\mu) & \vdots & \ddots & & & & \\ & H_\mu(\mu+1) & \ddots & & & & \\ & & & H_0(t) & & & \\ & & \ddots & H_1(t+1) & H_0(t+1) & & \\ & & & \vdots & \vdots & \ddots & \\ & & & H_\mu(t+\mu) & H_{\mu-1}(t+\mu) & \cdots & H_0(t+\mu) \end{pmatrix}.$$

Again, only non-zero component matrices are illustrated in the parity check matrix above. Each column and/or row of component matrices comprises $L$ component matrices with $\mu+1$ non-zero component matrices $H_0$, ..., $H_\mu$ and $L$ - $(\mu+1)$ zero component matrices.

When considering the special case of a syndrome former memory of $\mu = 1$ and a time invariant code, the parity check matrix **H** of the LDPC convolutional encoding rule takes the following form:

$$\mathbf{H}_{conv} = \begin{pmatrix} \mathbf{H}_0 & & & & & \mathbf{H}_1 \\ \mathbf{H}_1 & \mathbf{H}_0 & & & & \\ & \mathbf{H}_1 & \ddots & & & \\ & & \ddots & \mathbf{H}_0 & & \\ & & & \mathbf{H}_1 & \mathbf{H}_0 & \\ & & & & \mathbf{H}_1 & \mathbf{H}_0 \end{pmatrix}.$$

Again, only non-zero component matrices are illustrated in the parity check matrix.

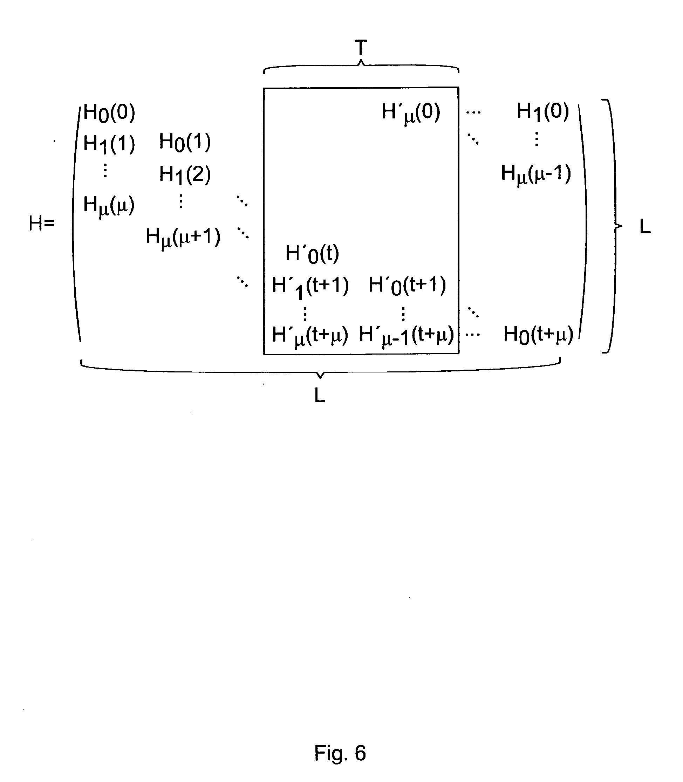

An LDPC tail-biting convolutional encoding rule does not have a rate loss regardless of $L$, i.e., $R_L = R$. A tail-biting code has however, in its most basic form, a performance that is significantly worse than the performance of the conventionally terminated code. Instead of terminating an LDPC convolutional code, leading to a relatively high rate loss, the present disclosure proposes to shorten some positions in a certain portion of the codeword, such that the rate loss is minimized and the decoding wave is still triggered. For this we may take a tail-biting code with $L$ positions and pick $T$ positions within the code, wherein each position corresponds to one component matrix in the above description. At each of the $T$ positions we may shorten a portion of $\alpha N$ of the associated code bits, i.e., we set them to zero and do not transmit them. This is equivalent to effective component matrices with $\alpha N$ fewer variable nodes, i.e., columns. This is illustrated in **Fig. 6.**

Fig. 6 shows the above parity check matrix **H** of the tail-biting LDPC convolutional encoding rule having $L^2$ component matrices, wherein a row of the parity check matrix has a size corresponding to $L$ component matrices and a column of the parity check matrix has a size corresponding to $L$ component matrices. Further, the each row of the parity check matrix **H** may comprise $T < L$ shortened component matrices, leading to $L \cdot T$ shortened effective component matrices and $L \cdot (L - T)$ non-shortened effective component matrices within the parity check matrix H. In embodiments, the $T$ shortened effective component matrices should be adjacent component matrices. Further, all matrices in a column should be shortened in the same way. Here, "adjacent" also covers embodiments the "cyclic" case where one of two subsets of the $T$ component matrices ends on position $L$ - 1, while the other subset starts at position 0. Further, all component matrices corresponding to a column of a shortened component matrix may be shortened component matrices.

In the example of Fig. 6, the shortened effective component matrix $\mathbf{H}_{\mu'}(0)$ may have a dimension of $(M \times (1 - \alpha)N)$, while the non-shortened component matrix $\mathbf{H}_\mu(0)$ may have a dimension of $(M \times N)$. The same holds for the other shortened component matrices $\mathbf{H}_{x'}(t)$ and non-shortened component matrices $\mathbf{H}_x(t)$.

Embodiments propose introducing a random-like tail-biting spatially coupled $(d_v, d_c, L, \mu)$ ensemble. We may first lay out a set of positions indexed by $L$ integers $z \in \{0, 1, \dots, L-1\}$ on a circle. This circle represents the spatial dimension. We may further fix a syndrome former memory which is an integer $\mu > 0$. Consider $L$ sets of variable nodes each having $N$ nodes, and locate the sets in positions 0 to $L$-1. Similarly, locate $L$ sets of $M$ check nodes, each in positions 0 to $L$-1. The degree of each variable (check) node is randomly sampled according to the degree distribution $L(x)$ $(R(x))$

leading to *MR'*(1) sockets at each position. In the case of a regular ($d_v$, $d_c$) code, we have $L(x) = x^{dv}$ and $R(x) = x^{dc}$.

To construct a random instance of the SC-LDPC ensemble, we may connect the variable nodes to the check nodes in the following manner: Each of sockets of variable nodes at position $z$ is connected uniformly at random to a socket of check nodes within the range $\{z, ..., (z+\mu)$ mod $L\}$. At the end of this procedure, all *MR'*(1) sockets of check nodes are occupied.

One idea underlying the present disclosure is to take a block of $T$ consecutive positions $\{p, , ..., (p+T\text{-}1)$ mod $L\}$ and shorten (or mute) a fraction $\alpha N$ of the $N$ variable nodes at each of these positions to obtain $(1\text{-}\alpha)N$ variable nodes, respectively. In one context of the present disclosure, shortening means that we fix the value of the fraction $\alpha N$ of the $N$ variable nodes (i.e., codebits) to zero. As the value is also known at a receiver, this means that we do not need to transmit the values. By selecting and varying $\alpha$ and $T$ we can select the rate loss of the code. If $T \geq \mu$, then the design rate of the code can be given by

$$R(\alpha, T) = 1 - \frac{M}{N} \times \frac{1 - (2\sum_{i=1}^{\mu}\left(\frac{\alpha i}{\mu+1}\right)^{d_c} - (T-\mu)\alpha^{d_c})/L}{1 - T\alpha/L}$$

This equation takes into account the fact that by removing variable nodes from the bipartite graph, it may occur with a certain probability that some of the check nodes will have no remaining connection after the shortening procedure. We may therefore modify the procedure of shortening such that this situation is avoided, i.e., the remaining check nodes will all have at least 2 remaining connections. In that latter case, the rate is given by

$$R(\alpha, T) = 1 - \frac{M}{N} \times \frac{1}{1 - T\alpha/L}$$

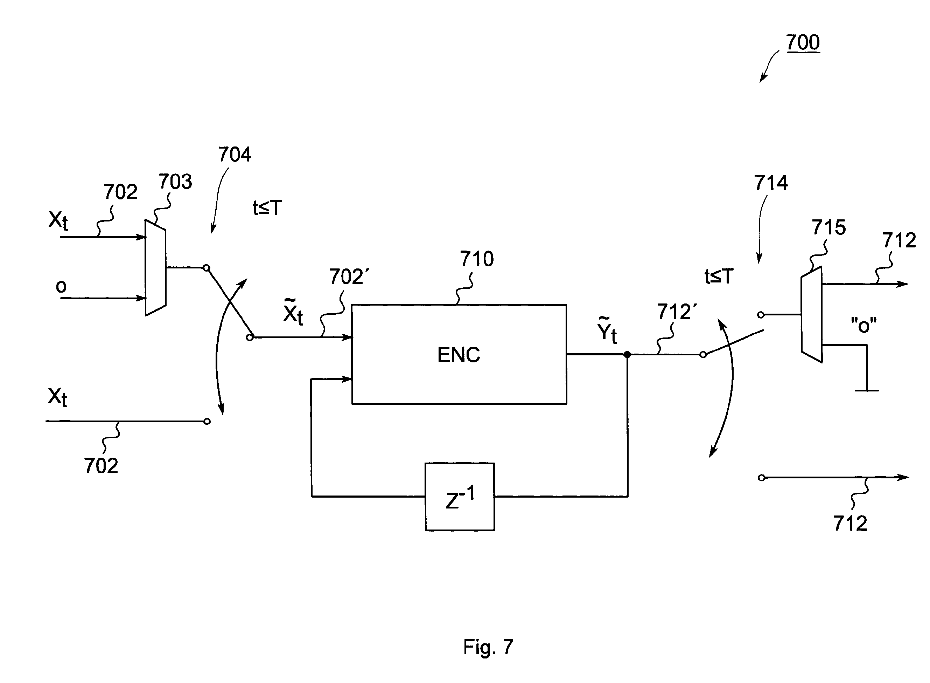

A block diagram of an example encoder 700 is shown in **Fig.** 7. The person skilled in the art will appreciate, however, that there are various alternatives for implementing embodiments. The example encoder 700 of Fig. 7 is based on the assumption that the first $T$ component matrices in a row of **H** shall correspond to shortened Tanner graphs, i.e., Tanner graphs with fewer or muted variable nodes. Also, for sake of simplicity only $\mu = 1$ is considered.

As long as time index $t$ of an info bit stream $\mathbf{x}_t$ (reference numeral 702) corresponds to encoding with at least one of the shortened component matrices, the switches 704 and 715 are in the upper position indicated in Fig. 7. Otherwise, the switches are changed to the respective lower signal branches. In this case a signal block of $k$ input bits for the encoder 710 is generated from $k\left(1 - \frac{\alpha}{R}\right)$ info bits $\mathbf{x}_t$ multiplexed with $k\left(\frac{\alpha}{R}\right)$ zeros by multiplexer 703. Thereby the positions of the no-information-carrying zeros correspond to the $\alpha N$ disregarded (or muted) variable nodes of the $T$ shortened component matrices. Note, however, that the shortening by removing nodes in the bipartite graph may also be interpreted differently. In the switched implementation of Fig. 7, the nodes are effectively "muted" (i.e., set to "0" or virtually removed) by filling the information bit stream with zeros at those positions which will be removed. In this case, the first $T$ component matrices in a row of **H** may still be of the same dimension as the $L$-$T$ remaining component matrices in a row of **H.** Here, the shortening of the respective variable nodes of the first $T$ component matrices is achieved by setting input bits associated with the shortened (muted) variable nodes to a predefined value, e.g. zero, by multiplexer 703. In other words, the encoding behavior may be achieved by manipulating the input/output streams of the encoder 710 accordingly. Nonetheless, according to common practice, the encoding behavior can be described or defined by a partly shortened parity check matrix.

The resulting input bit stream $\tilde{\mathbf{x}}_t$ (reference numeral 702') is encoded by LDPC convolutional encoder 710 to obtain an encoded output stream $\tilde{\mathbf{y}}_t$ (reference numeral 712'), which is fed back to one input of LDPC convolutional encoder 710. As long as the switches 704 and 715 are in the upper position shown in Fig. 7, $\alpha N$ of the resulting $N$ code bits corresponding to the muted variable nodes are set to zero, and disregarded after the demultiplexer 715 and hence are not transmitted.

Note that also other encoder implementations are possible. The switches 704 and 715 can be omitted, for example, if the encoder input block size can be varied between $k$ info bits for non-shortened component matrices and $k\left(1 - \frac{\alpha}{R}\right)$ info bits for shortened component matrices. In this case the dimensions of the spatially coupled component Tanner graphs vary between (M $\times$ $N$) nodes for non-shortened component matrices and ($M$ $\times$ $(1\text{-}\alpha)N$) for shortened component matrices.

In some embodiments, an encoded signal block corresponding to one or more of the shortened component matrices, e.g. the first $T$ of $L$ encoded signal blocks, may be modulated with a different modulation format than an encoded signal block corresponding to one or more of the non-shortened component matrices. For example, a modulation format associated with one or more of the shortened component matrices may be of lower order (e.g. 32-QAM) than a modulation format associated with one or more of the non-shortened component matrices (e.g. 64-QAM).

For each $T$, we can use the technique of density evolution to find the smallest $\alpha(T)$ such that the code can be decoded successfully. We assume the code is used when the SNR (or the channel entropy) is very close to the MAP threshold of the ensemble. This is due to the fact that the error rate of a given code becomes smaller and smaller by increasing the SNR (or upgrading the channel). Finally, we choose the pair $(\alpha^*, T^*)$ which maximizes the rate $R(\alpha, T)$. For instance, if we consider a spatially coupled LDPC code with $d_v=4$, $d_c=20$, $L=32$ and $\mu=3$. With these parameters, the design rate of conventional spatially coupled LDPC codes is 0.779. Therefore, it has a rate loss of 2.58%, meaning a larger required overhead.

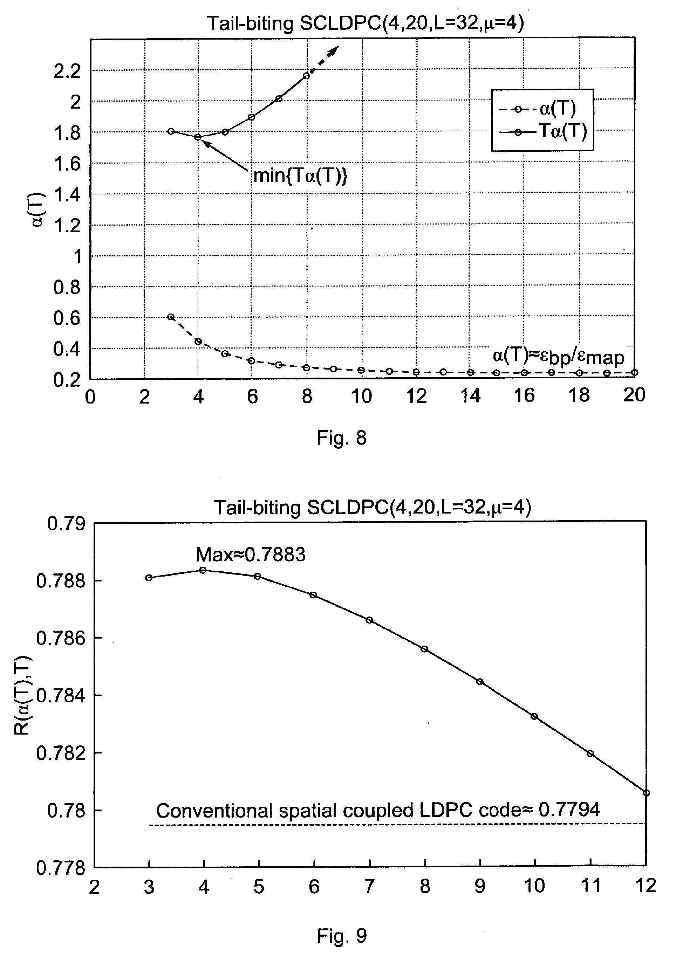

In **Fig. 8,** we compute the minimum $\alpha(T)$ when the transmission is performed over binary erasure channels, which is a good model for optical channels at large SNRs. In a binary erasure channel, each bit is erased or passed by the channel. The bits are erased randomly and independently with probability $\varepsilon$. The MAP threshold of the LDPC(4,20) code is about 0.1971. We observe that $\alpha(T)$ is decreasing in terms of $T$. Moreover, the minimum $T\alpha(T)$ gives the maximum design rate. The design rate $R(\alpha(T),T)$ is plotted in **Fig. 9**. We observe that for a large value of $T$, our schemes have a larger rate than the conventional spatially-coupled LDPC code, thus minimizing the rate loss and allowing to operate the schemes at better spectral efficiencies. The rate reaches its maximum of 0.788 for $T=4$ and $\alpha=0.441$. This code has a rate loss of only 1.49%, i.e., the rate loss is decreased by about 40% with the proposed embodiment.

We may further consider a protograph-based construction of terminated spatially coupled (also commonly called terminated convolutional) LDPC codes according to embodiments of the present disclosure. Thereby a protograph is a convenient way of describing certain sub-classes of LDPC codes. Protograph codes are constructed from a so-called P-cover of a relatively small graph which conveys the main properties of the code. The protograph serves as a blueprint for constructing LDPC codes of arbitrary size whose performance can be predicted by analyzing the protograph. A protograph can be any Tanner graph, typically one with a relatively small number of nodes. A protograph G = $(V,$ C, $E)$ comprises a set of variable nodes $V$, a set of check nodes C, and a set of edges $E$. Each edge $e \in E$ connects a variable node $v_e \in V$ to a check node $c_e \in$ C. Parallel edges are permitted, so the mapping $e \to (v_e, c_e) \in V \times C$ is surjective and thus not necessarily 1:1. This means that in contrast to the graph representation of the LDPC code, the protograph may contain multiple edges between variable and check nodes. The code itself is constructed by placing P copies of the protograph next to each other (note that these have no interconnecting edges) and permuting the edges between the different copies of the protograph, such that the relation between the group of edges is respected.

This copy-and-permute operation for a protograph may be described by a protomatrix. An example of such a protomatrix is

$$\mathbf{B} = \begin{pmatrix} 1 & 2 & 0 \\ 2 & 1 & 3 \end{pmatrix}$$

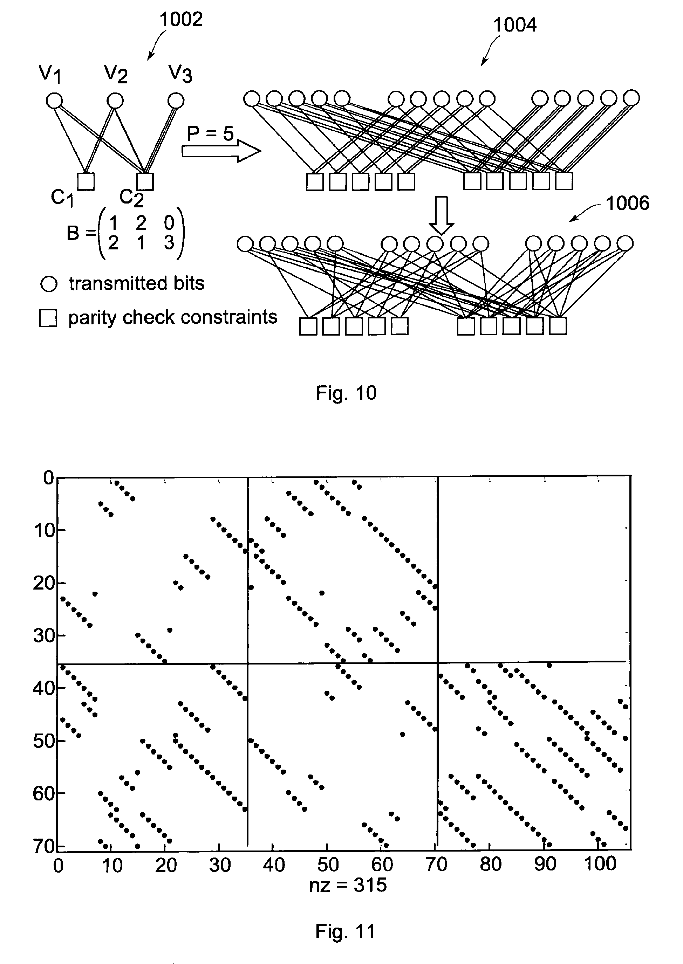

where the numbers or symbols in **B** denote the amount of parallel edges between the entries in the graph. Note that the permutation may be performed such that no parallel edges remain in the graph after permuting. **Fig. 10** shows an example of the copy-and-permute operation for generating a graph with P=5 using the example protomatrix **B.**

In Fig. 10, reference numeral 1002 denotes a template graph, i.e., the protograph, for the protomatrix **B**. According to the entries of the first row of **B** there is one edge connecting variable node $v_1$ to check node $c_1$. Two edges are connecting variable node $v_2$ with check node $c_1$. Zero edges are between variable node $v_3$ and check node $c_1$. According to the entries of the second row of **B** there are two edges connecting variable node $v_1$ to check node $c_2$. One edge is connecting variable node $v_2$ with check node $c_2$. Three edges are between variable node $v_3$ and check node $c_2$. Reference numeral 1004 denotes the graph resulting of the copy-operation with $P=5$ using protomatrix **B**. Finally, reference numeral 1006 denotes the graph resulting of the permute-operation based on graph 1004.

Most LDPC codes that are implemented today are so-called Quasi-Cyclic (QC) LDPC codes. They have a parity-check matrix **H** with a structure that allows for inherent parallelization of an LDPC decoder and leads to an efficient encoder realization. Almost all LDPC codes utilized in practice belong to the class of QC-LDPC codes.

QC-LDPC codes may be constructed using a so-called lifting matrix **A**. The parity-check matrix **H** may be constructed from the lifting matrix **A** by replacing each element of **A** with either an all-zero matrix of size $S \times S$ or a permutation matrix, e.g., a cyclically permuted identity matrix, of size $S \times S$. We adhere to the following notation: S denotes the lifting factor, i.e., the size of the all-zero or cyclically shifted identity matrix. If the entry of **A** at row $m$ and column $i$ corresponds to a predetermined value, e.g., $A_{m,i}$ = -1, then the all-zero matrix of size $S \times S$ is used, and if $A_{m,i} \geq 0$, $A_{m,i}$ may denote how many cyclic right shifts of the identity matrix are performed. If dim(**H**) = $M \times N$, then dim(A) = $M' \times N'$, with $M'=M/S$ and $N'=N/S$. We furthermore define the set $\mathcal{N}_A$ ($m$) to denote the positions of the non "-1" entries (or any other entry denoting a void replacement) in the $m$-th row of **A**, i.e., $\mathcal{N}_A(m) = \{i: A_{m,i} \neq -1\}$.

Let us illustrate the construction of QC-LDPC codes by a small (artificial) example with a lifting matrix of size dim(**A**) = $3 \times 5$ and a lifting factor of S = 5 (leading to dim(**H**) = $S \cdot$dim(**A**) = 15x25. This corresponds to a code of design rate $r$ = 0.4, or an overhead of 150%, respectively).

$$\mathbf{A} = \begin{pmatrix} -1 & 0 & 1 & 1 & 2 \\ 2 & -1 & 4 & 2 & 1 \\ 1 & 3 & -1 & 3 & 1 \end{pmatrix} \rightarrow \mathbf{H} =$$

Note that for the sake of clarity again only non-zero entries are show in the description of **H.** Note that **H** represents a binary matrix. The extension to an $x$-ary matrix for higher-order modulation can be achieved by replacing the non-zero elements by according non-zero elements of GF($x$) or $\mathbb{Z}_x$. The selection of the ring of integer numbers modulo $x$ is also frequently used in coded modulation. Both $\mathbb{Z}_x$ and GF($x$) are identical if $x$ is prime. Generally the value $S$ corresponds to the parallelism that can be implemented in a QC-LDPC decoder.

In order to realize protograph-based QC-LDPC codes, we may employ a double-lifting procedure. First, from the protomatrix **B,** we may generate by the copy-and-permute operation a lifting matrix **A** and then optimize the non-void entries of **A** in order to get desired code properties. Using this lifting matrix **A,** we can then construct the parity-check-matrix **H** with the desired properties. We thus have dim(**H**) = $M''SP \times N''SP$, with dim(**B**)=$M' \times N''$.

Let us illustrate the generation of an exemplary parity-check matrix **H** of a protograph-based QC-LDPC based on two-fold lifting by means of an example with P=5 and $S$=7. We start with the same exemplary protomatrix

$$\mathbf{B} = \begin{pmatrix} 1 & 2 & 0 \\ 2 & 1 & 3 \end{pmatrix},$$

which has been already introduced above and illustrated in Fig. 10. One possible P=5 cover shown in Fig. 10 of the matrix **B** leads to a (parity-check) matrix **H'** that may be described by

$$\mathbf{H'} = \left(\begin{array}{ccccc|ccccc|ccccc} 1 & & & & & & 1 & 1 & & & & & & & \\ & & & & 1 & 1 & & & 1 & & & & & & \\ & & & 1 & & 1 & & & & 1 & & & & & \\ 1 & & & & & & 1 & & & 1 & & & & & \\ & 1 & & & & & & 1 & 1 & & & & & & \\ \hline 1 & & & & & 1 & & & 1 & & & 1 & 1 & 1 & \\ 1 & & 1 & & & & & & & 1 & & 1 & & 1 & 1 \\ & & 1 & 1 & & 1 & & & & & & & 1 & 1 & 1 \\ & 1 & & & 1 & & 1 & & & & 1 & 1 & & 1 & \\ & 1 & 1 & & & & & & 1 & & 1 & & 1 & & 1 \end{array}\right).$$

The bipartite graph 1006 of the matrix **H'** is shown in the bottom right corner of Fig. 10. Note that the $P \times P$ squares of **H'** are filled with non-overlapping superpositions of permutation matrices preserving the number of "1"s per row and column of each PxP sub-matrix. Using the matrix **H'**, we can get the lifting matrix **A** by properly selecting the cyclic shifts. An exemplary lifting matrix **A** is

$$\mathbf{A} = \left(\begin{array}{ccccc|ccccc|ccccc} -1 & 3 & -1 & -1 & -1 & -1 & 5 & 5 & -1 & -1 & -1 & -1 & -1 & -1 & -1 \\ -1 & -1 & -1 & -1 & 0 & 3 & -1 & -1 & 0 & -1 & -1 & -1 & -1 & -1 & -1 \\ -1 & -1 & -1 & 2 & -1 & 1 & -1 & -1 & -1 & 0 & -1 & -1 & -1 & -1 & -1 \\ 6 & -1 & -1 & -1 & -1 & -1 & 6 & -1 & -1 & 3 & -1 & -1 & -1 & -1 & -1 \\ -1 & -1 & 6 & -1 & -1 & -1 & -1 & 4 & 2 & -1 & -1 & -1 & -1 & -1 & -1 \\ \hline 0 & -1 & -1 & -1 & 0 & -1 & -1 & 2 & -1 & -1 & 5 & 4 & 6 & -1 & -1 \\ 4 & -1 & -1 & 1 & -1 & -1 & -1 & -1 & -1 & 1 & -1 & 2 & -1 & 0 & 5 \\ -1 & -1 & 1 & 0 & -1 & 0 & -1 & -1 & -1 & -1 & -1 & -1 & 6 & 6 & 6 \\ -1 & 4 & -1 & -1 & 0 & -1 & 4 & -1 & -1 & -1 & 2 & 0 & -1 & 6 & -1 \\ -1 & 2 & 1 & -1 & -1 & -1 & -1 & -1 & 5 & -1 & 0 & -1 & 0 & -1 & 3 \end{array}\right),$$

where the 1s of **H'** have been replaced by shift values in the range {0,1,...,$S$-1} (here $S$=7) and the 0s (not shown in the description of **H'** for clarity) have been replaced by "-1". The resulting exemplary parity-check matrix **H** has dimension $2PS \times 3PS$ = 70×105 and is visualized in **Fig. 11,** with the single dots representing the non-zero elements of the matrix.
In order to construct an exemplary spatially coupled protograph-based LDPC code used to achieve a channel utilization of approximately 0.8 bit/channel use with a 3-PSK modulation scheme, for example, we may generate exemplary $\mathbf{H}_0$ and $\mathbf{H}_1$ using the following exemplary protographs **Bo** and $\mathbf{B}_1$:

$$\mathbf{B}_0 = (2 \quad 1)$$

$$\mathbf{B}_1 = (2 \quad 3)$$

This may lead to the exemplary protograph $\mathbf{B}_{conv}$ with tailbiting structure defining an embodiment of a spatially coupled/convolutional LDPC code. Note that the right element of $\mathbf{B}_0$ is 1 in some embodiments.

$$\mathbf{B}_{conv} = \begin{pmatrix} 2 & 1 & & & & & & & 2 & 3 \\ 2 & 3 & 2 & 1 & & & & & & \\ & & 2 & 3 & 2 & 1 & & & & \\ & & & & 2 & 3 & 2 & 1 & & \\ & & & & & & 2 & 3 & 2 & 1 \end{pmatrix}$$

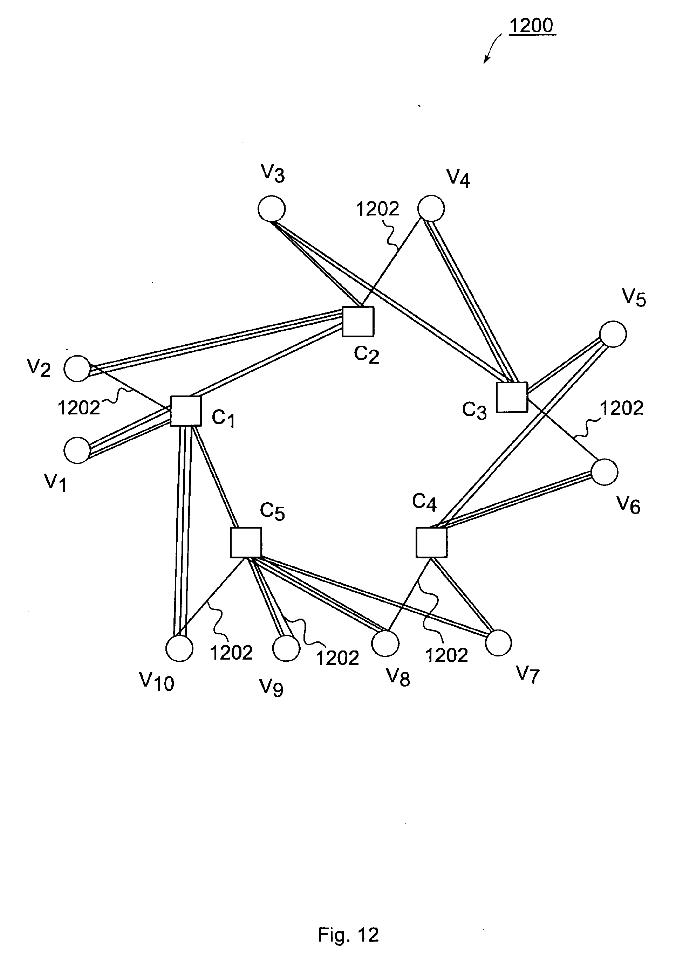

A simple protograph with $L=5$ corresponding to this protomatrix is shown in **Fig. 12**. The columns of the protomatrix corresponding to the variable nodes are marked with $v_1$ to $v_{10}$ in Fig. 12. The rows of the protomatrix corresponding to the check nodes are marked with $c_1$ to $c_5$ in Fig. 10. The tail-biting structure of the protomatrix is reflected by the edges between $c_1$ and variable nodes $v_9$ and $v_{10}$

The edges corresponding to the "1" in each row of the protomatrix $\mathbf{B}_{conv}$ are marked by lines 1202 in Fig. 12. The reason for this is the following: We do not permute these edges in the copy-and-permute operation and in the lifting process to generate the QC-code. We replace these edges corresponding to the rightmost "1" of each row in the protomatrix $\mathbf{B}_{conv}$ by an identity matrix. This structure may facilitate encoding.

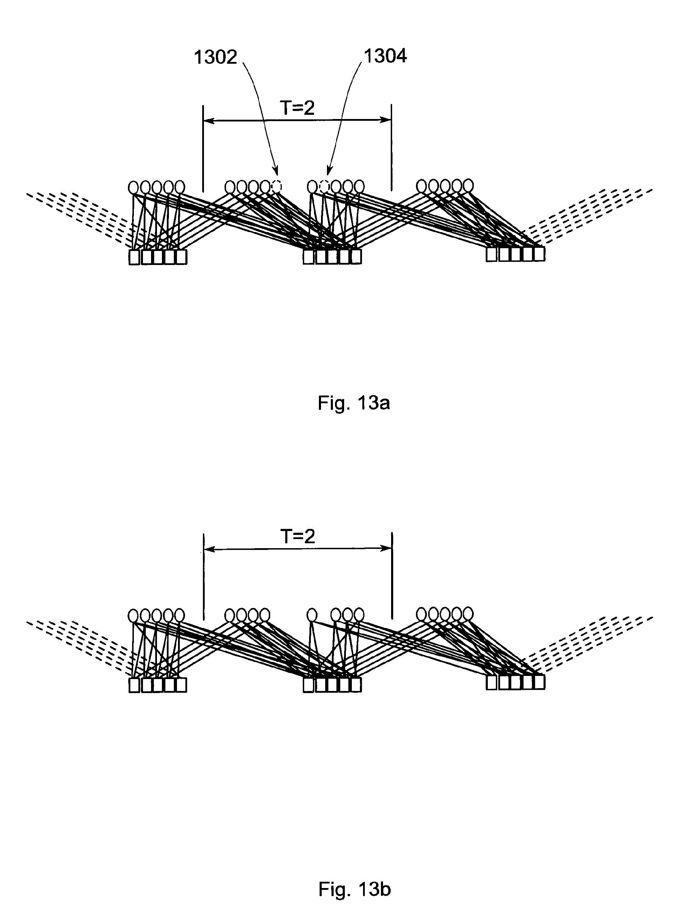

A portion of the LDPC graph resulting from the 5-cover of the protograph is shown in **Fig. 13a** for the simple illustrative example of $P = 5$. If we assume that $T = 2$ and $\alpha = 1/5$, then we may shorten a single variable node in the $T$ positions selected. In this case, we have to shorten single positions marked as variable nodes 1302 and 1304. As these positions are not transmitted, we can remove ("mute") the variable nodes 1302 and 1304 and associated positions, shown in **Fig. 13b**. This effectively reduces the check node degrees at the $T$ positions which leads to the graph being more sparse in these positions and effectively starts the decoding wave.

To summarize, the present disclosure proposes LDPC convolutional codes which may be described by coupled bipartite graph components (such as Tanner graphs). Thereby, not all bipartite graph components or component graphs have the same number of variable nodes. Some bipartite graph components - so-called shortened bipartite graph components - have a reduced number of variable nodes compared to other bipartite graph components - so-called non-shortened bipartite graph components. Thereby, shortened bipartite graph components may be represented by so-called shortened component matrices, while non-shortened bipartite graph components may be represented by so-called non-shortened component matrices of a parity check matrix. Said parity check matrix may have a tail-biting structure.

The proposal may improve the Signal-to-Noise Ratio (SNR) and/or spectral efficiency performance of optical transport systems while keeping Very-Large-Scale Integration (VLSI) complexity low. An advantage of the new solution may be that the spectral efficiency of the system can be improved as the effective coding overhead may be reduced while keeping the correction abilities constant.

The description and drawings merely illustrate the principles of the present disclosure. It will thus be appreciated that those skilled in the art will be able to devise various arrangements that, although not explicitly described or shown herein, embody the principles of the present disclosure. Furthermore, all examples recited herein are principally intended expressly to be only for pedagogical purposes to aid the reader in understanding the principles and the concepts contributed by the inventor(s) to furthering the art, and are to be construed as being without limitation to such specifically recited examples and conditions. Moreover, all statements herein reciting principles, aspects, and embodiments of the present disclosure, as well as specific examples thereof, are intended to encompass equivalents thereof.

Functional blocks shall be understood as functional blocks comprising circuitry that is configured to perform a certain function, respectively. Hence, a "module or entity for s.th." may as well be understood as a "module or entity being adapted or suited for s.th.". A module or entity being adapted for performing a certain function does, hence, not imply that such means necessarily is performing said function (at a given time instant).

Functions of various elements shown in the figures, including any functional blocks may be provided through the use of dedicated hardware, such as electrical circuitry of a processor, a controller, etc. as well as hardware capable of executing software in association with appropriate software. Moreover, any entity described herein as functional block, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Furthermore, the following claims are hereby incorporated into the Detailed Description, where each claim may stand on its own as a separate embodiment. While each claim may stand on its own as a separate embodiment, it is to be noted that - although a dependent claim may refer in the claims to a specific combination with one or more other claims - other embodiments may also include a combination of the dependent claim with the subject matter of each other dependent claim. Such combinations are proposed herein unless it is stated that a specific combination is not intended. Furthermore, it is intended to include also features of a claim to any other independent claim even if this claim is not directly made dependent to the independent claim.

It is further to be noted that methods disclosed in the specification or in the claims may be implemented by a device having means for performing each of the respective steps of these methods.

Further, it is to be understood that the disclosure of multiple steps or functions disclosed in the specification or claims may not be construed as to be within the specific order. Therefore, the disclosure of multiple steps or functions will not limit these to a particular order unless such steps or functions are not interchangeable for technical reasons. Furthermore, in some embodiments a single step may include or may be broken into multiple sub steps. Such sub steps may be included and part of the disclosure of this single step unless explicitly excluded.

**Claims**

1.  Method (400) for encoding a signal (402), the method comprising:

    encoding (410) the signal (402) based on an LDPC convolutional encoding rule to obtain an encoded signal (412), wherein the LDPC convolutional encoding rule is defined by a parity check matrix having $L^2$, $L \in \mathbb{N}$, component matrices, a row of the parity check matrix corresponding to $L$ component matrices and a column of the parity check matrix corresponding to $L$ component matrices,
    wherein the $L^2$ component matrices comprise shortened component matrices and non-shortened component matrices,
    wherein a shortened component matrix represents a bipartite graph with fewer variable nodes than a non-shortened component matrix.

2.  The encoding method (400) of claim 1, wherein a shortened component matrix represents a bipartite graph with the same number of check nodes as a non-shortened component matrix.

3.  The encoding method (400) of claim 1, wherein a non-shortened component matrix has a dimension ($M \times N$) and wherein a shortened component matrix has a dimension ($M \times (1 - \alpha)N$).

4.  The encoding method (400) of claim 1, wherein a row of $L$ component matrices comprises $T$ shortened component matrices and $L$-$T$ non-shortened component matrices.

5.  The encoding method (400) of claim 4, wherein the $T$ shortened submatrices are adjacent submatrices.

6.  The encoding method (400) of claim 4, wherein all component matrices corresponding to a column of a shortened component matrix are shortened component matrices.

7.  The encoding method (400) of claim 1, wherein a column of $L$ component matrices of the parity check matrix has the same number of non-zero component matrices as a row of $L$ component matrices of the parity check matrix.

8.  The encoding method (400) of claim 7, wherein the number of non-zero component matrices corresponds to $\mu$+1, wherein $\mu < L$ denotes the syndrome former memory of the LDPC convolutional encoding rule.

9.  The encoding method (400) of claim 1, wherein the parity check matrix of the LDPC convolutional encoding rule corresponds to the tailbiting form

$$H = \begin{pmatrix} H_0(0) & & & & H_\mu(0) & \cdots & H_1(0) \\ H_1(1) & H_0(1) & & & & \ddots & \vdots \\ \vdots & H_1(2) & & & & & H_\mu(\mu-1) \\ H_\mu(\mu) & \vdots & \ddots & & & & \\ & H_\mu(\mu+1) & \ddots & & & & \\ & & & H_0(t) & & & \\ & & \ddots & H_1(t+1) & H_0(t+1) & & \\ & & & \vdots & \vdots & \ddots & \\ & & & H_\mu(t+\mu) & H_{\mu-1}(t+\mu) & \cdots & H_0(t+\mu) \end{pmatrix},$$

wherein each column and/or row of component matrices comprises $L$ component matrices with $\mu+1$ non-zero component matrices, wherein $\mu$ denotes the syndrome former memory of the LDPC convolutional encoding rule.

10. The encoding method (400) of claim 1, wherein a shortened component matrix represents a bipartite graph with $(1-\alpha)N$ variable nodes, with $\alpha < 1$, and wherein a non-shortened component matrix represents a bipartite graph with $N$ variable nodes, the method further comprising:

for each component matrix of the parity check matrix, receiving a signal block (702') of $k$ input bits; and
providing $(1-\alpha)N$ code bits (712) based on the block of input bits (702') and each of the shortened component matrices, or
providing $N$ code bits (712) based on the block of input bits (702') and each of the non-shortened component matrices.

11. The encoding method (400) of claim 1, further comprising:

modulating an encoded signal block corresponding to one or more of the shortened component matrices with a different modulation format than an encoded signal block corresponding to one or more of the non-shortened component matrices.

12. The encoding method (400) of claim 11, wherein a modulation format associated with one or more of the shortened component matrices is of lower order than a modulation format associated with one or more of the non-shortened component matrices.

13. A method (450) for decoding an encoded signal (412), the method comprising:

decoding (460) the encoded signal (412) based on an LDPC convolutional decoding rule to obtain a decoded signal (462),
wherein the LDPC convolutional decoding rule is defined by a parity check matrix having $L^2$, $L \in \mathbb{N}$, component matrices, a row of the parity check matrix corresponding to $L$ component matrices and a column of the parity check matrix corresponding to $L$ component matrices,
wherein the $L^2$ component matrices comprise shortened component matrices and non-shortened component matrices,
wherein a shortened component matrix represents a bipartite graph with fewer variable nodes than a non-shortened component matrix.

14. Apparatus (700) for encoding a signal (702'), the apparatus comprising:

an LDPC convolutional encoder (710) having an input for the signal (702') and an output for an encoded signal (712),
wherein the LDPC convolutional encoder (710) is configured to encode the signal based on an LDPC convolutional encoding rule to obtain the encoded signal (712),
wherein the LDPC convolutional encoding rule is defined by a parity check matrix having $L^2$, $L \in \mathbb{N}$, component matrices, a row of the parity check matrix corresponding to $L$ component matrices and a column of the parity check matrix corresponding to $L$ component matrices,
wherein the $L^2$ component matrices comprise shortened component matrices and non-shortened component matrices,
wherein a shortened component matrix represents a bipartite graph with fewer variable nodes than a non-shortened component matrix.

15. Apparatus for decoding an encoded signal (412), the apparatus comprising:

an LDPC convolutional decoder having an input for the encoded signal (412) and an output for a decoded signal (462),
wherein the LDPC convolutional decoder is configured to decode the encoded signal based on an LDPC convolutional decoding rule to obtain the decoded signal (462),
wherein the LDPC convolutional decoding rule is defined by a parity check matrix having $L^2$, $L \in \mathbb{N}$, component matrices, a row of the parity check matrix corresponding to $L$ component matrices and a column of the parity check matrix corresponding to $L$ component matrices,
wherein the $L^2$ component matrices comprise shortened component matrices and non-shortened component matrices,
wherein a shortened component matrix represents a bipartite graph with fewer variable nodes than a non-shortened component matrix.

**Amended claims in accordance with Rule 137(2) EPC.**

1. Method (400) for encoding a signal (402), the method comprising:

encoding (410) the signal (402) based on an LDPC convolutional encoding rule to obtain an encoded signal (412), wherein the LDPC convolutional encoding rule is defined by a parity check matrix having a tail-biting form and consisting of $L^2$, $L \in \mathbb{N}$, component matrices, a row of the parity check matrix corresponding to $L$ component matrices and a column of the parity check matrix corresponding to $L$ component matrices,
wherein the $L^2$ component matrices comprise shortened component matrices and non-shortened component matrices,
wherein a shortened component matrix represents a bipartite graph with fewer variable nodes than a non-shortened component matrix; and
modulating an encoded signal block corresponding to one or more of the shortened component matrices with a different modulation format than an encoded signal block corresponding to one or more of the non-shortened component matrices.

2. The encoding method (400) of claim 1, wherein a shortened component matrix represents a bipartite graph with the same number of check nodes as a non-shortened component matrix.

3. The encoding method (400) of claim 1, wherein a non-shortened component matrix has a dimension ($\mathbf{M} \times \mathbf{N}$) and wherein a shortened component matrix has a dimension ($\mathbf{M} \times (\mathbf{1} - \alpha)\mathbf{N}$).

4. The encoding method (400) of claim 1, wherein a row of $L$ component matrices comprises $T$ shortened component matrices and $L$-$T$ non-shortened component matrices.

5. The encoding method (400) of claim 4, wherein the $T$ shortened submatrices are adjacent submatrices.

6. The encoding method (400) of claim 4, wherein all component matrices corresponding to a column of a shortened component matrix are shortened component matrices.

7. The encoding method (400) of claim 1, wherein a column of $L$ component matrices of the parity check matrix has the same number of non-zero component matrices as a row of $L$ component matrices of the parity check matrix.

8. The encoding method (400) of claim 7, wherein the number of non-zero component matrices corresponds to $\mu+1$, wherein $\mu < L$ denotes the syndrome former memory of the LDPC convolutional encoding rule.

9. The encoding method (400) of claim 1, wherein the parity check matrix of the LDPC convolutional encoding rule corresponds to the tailbiting form

$$H = \begin{pmatrix} H_0(0) & & & & & H_\mu(0) & \cdots & H_1(0) \\ H_1(1) & H_0(1) & & & & & \ddots & \vdots \\ \vdots & H_1(2) & & & & & & H_\mu(\mu-1) \\ H_\mu(\mu) & \vdots & \ddots & & & & & \\ & H_\mu(\mu+1) & \ddots & & & & & \\ & & & H_0(t) & & & & \\ & & \ddots & H_1(t+1) & H_0(t+1) & & & \\ & & & \vdots & \vdots & \ddots & & \\ & & & H_\mu(t+\mu) & H_{\mu-1}(t+\mu) & \cdots & H_0(t+\mu) \end{pmatrix},$$

wherein each column and/or row of component matrices comprises $L$ component matrices with $\mu+1$ non-zero component matrices, wherein $\mu$ denotes the syndrome former memory of the LDPC convolutional encoding rule.

10. The encoding method (400) of claim 1, wherein a shortened component matrix represents a bipartite graph with $(1-\alpha)N$ variable nodes, with $\alpha < 1$, and wherein a non-shortened component matrix represents a bipartite graph with $N$ variable nodes, the method further comprising:

for each component matrix of the parity check matrix, receiving a signal block (702') of $k$ input bits; and
providing $(1-\alpha)N$ code bits (712) based on the block of input bits (702') and each of the shortened component matrices, or
providing $N$ code bits (712) based on the block of input bits (702') and each of the non-shortened component matrices.

11. The encoding method (400) of claim 1, wherein a modulation format associated with one or more of the shortened component matrices is of lower order than a modulation format associated with one or more of the non-shortened component matrices.

12. A method (450) for decoding an encoded signal (412) based on an LDPC convolutional decoding rule to obtain a decoded signal (462), wherein the LDPC convolutional decoding rule is defined by a parity check matrix having a tail-biting form and consisting of $L^2$, $L \in \mathbb{N}$, , component matrices, a row of the parity check matrix corresponding to $L$ component matrices and a column of the parity check matrix corresponding to $L$ component matrices, wherein the $L^2$ component matrices comprise shortened component matrices and non-shortened component matrices, wherein a shortened component matrix represents a bipartite graph with fewer variable nodes than a non-shortened component matrix, the method comprising:

demodulating an encoded signal block corresponding to one or more of the shortened component matrices using a different modulation format than an encoded signal block corresponding to one or more of the non-shortened component matrices; and
decoding (460) the encoded signal (412) based on the LDPC convolutional decoding rule to obtain a decoded signal (462).

13. Apparatus (700) for encoding a signal (702'), the apparatus comprising:

an LDPC convolutional encoder (710) having an input for the signal (702') and an output for an encoded signal (712),
wherein the LDPC convolutional encoder (710) is configured to encode the signal based on an LDPC convolutional encoding rule to obtain the encoded signal (712),

wherein the LDPC convolutional encoding rule is defined by a parity check matrix having a tail-biting form and consisting of $L^2$, $L \in \mathbb{N}$, component matrices, a row of the parity check matrix corresponding to $L$ component matrices and a column of the parity check matrix corresponding to $L$ component matrices,

wherein the $L^2$ component matrices comprise shortened component matrices and non-shortened component matrices,

wherein a shortened component matrix represents a bipartite graph with fewer variable nodes than a non-shortened component matrix; and

a modulator configured to modulate an encoded signal block corresponding to one or more of the shortened component matrices with a different modulation format than an encoded signal block corresponding to one or more of the non-shortened component matrices.

14. Apparatus for decoding an encoded signal (412) based on an LDPC convolutional decoding rule to obtain a decoded signal (462), wherein the LDPC convolutional decoding rule is defined by a parity check matrix having a tail-biting form and consisting of $L^2$, $L \in \mathbb{N}$, component matrices, a row of the parity check matrix corresponding to $L$ component matrices and a column of the parity check matrix corresponding to $L$ component matrices, wherein the $L^2$ component matrices comprise shortened component matrices and non-shortened component matrices, wherein a shortened component matrix represents a bipartite graph with fewer variable nodes than a non-shortened component matrix, the apparatus comprising:

a demodulator configured to demodulate an encoded signal block corresponding to one or more of the shortened component matrices using a different modulation format than an encoded signal block corresponding to one or more of the non-shortened component matrices; and

an LDPC convolutional decoder having an input for the encoded signal (412) and an output for a decoded signal (462),

wherein the LDPC convolutional decoder is configured to decode the encoded signal based on the LDPC convolutional decoding rule to obtain the decoded signal (462).

$$\hat{z}_i$$

100

102

Check Node Operation

$$e_{m,i} = \prod_{j \in N(m) \setminus \{i\}} sign(t_{m,i}) \quad \min_{j \in N(m) \setminus \{i\}} |t_{m,j}|, \ \forall i \in N(m)$$

$$e_{m,i}^{(l+1)}$$

$$\hat{z}_i$$

$$t_{m,i}$$

Extrinsic
Memory $e_{m,i}$

$$e_{m,i}^{(l)}$$

104

Fig. 1

200

210

212

$X_t$

Spatially Coupled
Encoder

$y_t$

214

Modulation

230

$y_{t-1}$

$z^{-1}$

Optical
Channel

Windowed
SC-Decoder

Demodulation
DSP

224

222

220

Fig. 2

Fig. 3

Fig. 4a

$$H = \begin{array}{cccc} V1 & V2 & V3 & V4 \end{array}$$

$$\begin{array}{c} C1 \\ C2 \end{array} \quad H = \begin{pmatrix} 1 & 1 & 0 & 1 \\ 1 & 1 & 1 & 1 \end{pmatrix} \implies H' = \begin{pmatrix} 1 & 0 & 1 \\ 1 & 1 & 1 \end{pmatrix} \begin{array}{c} C1 \\ C2 \end{array}$$

$$\begin{array}{ccc} V_1{}' & V_2{}' & V_3{}' \end{array}$$

Fig. 4b

$$H = \begin{pmatrix} H_{11} & H_{12} & H_{13} & H_{14} \\ H_{21} & \ddots & & \vdots \\ H_{31} & & \ddots & \vdots \\ H_{41} & \cdots & \cdots & H_{44} \end{pmatrix}$$

500

Fig. 5

$$
H = \begin{pmatrix}
H_0(0) & & & & H'_\mu(0) & \cdots & H_1(0) \\
H_1(1) & H_0(1) & & & & \ddots & \vdots \\
\vdots & H_1(2) & & & & & H_\mu(\mu-1) \\
H_\mu(\mu) & \vdots & \ddots & & & & \\
& H_\mu(\mu+1) & \ddots & & H'_0(t) & & \\
& & \ddots & & H'_1(t+1) & H'_0(t+1) & \ddots \\
& & & & \vdots & \vdots & \ddots \\
& & & & H'_\mu(t+\mu) & H'_{\mu-1}(t+\mu) & \cdots & H_0(t+\mu)
\end{pmatrix}
$$

Fig. 6

Fig. 7

Tail-biting SCLDPC(4,20,L=32,μ=4)

Fig. 8

Tail-biting SCLDPC(4,20,L=32,μ=4)

Fig. 9

$$B = \begin{pmatrix} 1 & 2 & 0 \\ 2 & 1 & 3 \end{pmatrix}$$

○ transmitted bits

□ parity check constraints

Fig. 10

nz = 315

Fig. 11

Fig. 12

Fig. 13a

Fig. 13b

**Europäisches Patentamt**
**European Patent Office**
**Office européen des brevets**

## EUROPEAN SEARCH REPORT

Application Number

EP 15 15 1496

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | MITCHELL D., LENTMAIER M., COSTELLO D.: "On the minimum distance of generalized spatially coupled LDPC codes", 2013 IEEE INTERNATIONAL SYMPOSIUM ON INFORMATION THEORY, IEEE, 7 July 2013 (2013-07-07), pages 1874-1878, XP032496913, ISSN: 2157-8095, DOI: 10.1109/ISIT.2013.6620551 [retrieved on 2013-10-03] * section III "Termination of GLDPCC codes" * ----- | 1-10, 13-15 | INV. H03M13/11 H03M13/25 H03M13/00 |
| Y | US 2007/162814 A1 (SHEN BA-ZHONG [US] ET AL) 12 July 2007 (2007-07-12) * paragraph [0067] - paragraph [0068] * * paragraph [0074] - paragraph [0077] * * paragraph [0104] - paragraph [0107] * ----- | 1-10, 13-15 | |
| A | LIN ZHOU ET AL: "Design of Nonbinary Rate-Compatible LDPC Codes Utilizing Bit-Wise Shortening Method", IEEE COMMUNICATIONS LETTERS, IEEE SERVICE CENTER, PISCATAWAY, NJ, US, vol. 14, no. 10, October 2010 (2010-10), pages 963-965, XP011317848, ISSN: 1089-7798 * cf. page 964, last complete paragraph * ----- | 11,12 | TECHNICAL FIELDS SEARCHED (IPC) H03M |

The present search report has been drawn up for all claims

| Place of search | Date of completion of the search | Examiner |
|---|---|---|
| Munich | 2 July 2015 | Farman, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 15 1496

This annex lists the patent family members relating to the patent documents cited in the above-mentioned European search report.
The members are as contained in the European Patent Office EDP file on
The European Patent Office is in no way liable for these particulars which are merely given for the purpose of information.

02-07-2015

| Patent document cited in search report | Publication date | Patent family member(s) | Publication date |
|---|---|---|---|
| US 2007162814 A1 | 12-07-2007 | US 2007162814 A1<br>US 2010083071 A1 | 12-07-2007<br>01-04-2010 |

EPO FORM P0459

For more details about this annex : see Official Journal of the European Patent Office, No. 12/82